# EUROPEAN PATENT APPLICATION

(11) **EP 4 534 964 A1**
(43) Date of publication of application: **09.04.2025**
(21) Application number: 24820249.1
(22) Date of filing: 10.07.2024

(54) **TEMPERATURE SENSOR, BATTERY, BATTERY PACK, AND HEALTH DETECTION METHOD, EVALUATION METHOD AND MONITORING SYSTEM THEREOF**

(30) Priority: 27.12.2023 CN 202323632484 U; 31.08.2023 CN 202311131026; 31.08.2023 CN 202311131033; 21.08.2023 CN 202311063037
(71) Applicant: Eve Power Co., Ltd., Jingmen, Hubei 448000 (CN)
(72) Inventor: YUAN, Dingding, Jingmen, Hubei 448000 (CN); ZHANG, Minhui, Jingmen, Hubei 448000 (CN); SONG, Chengmao, Jingmen, Hubei 448000 (CN); CHEN, Xianyang, Jingmen, Hubei 448000 (CN); FAN, Zhenxing, Jingmen, Hubei 448000 (CN); SUN, Fei, Jingmen, Hubei 448000 (CN); FAN, Guiping, Jingmen, Hubei 448000 (CN); QIN, Jingping, Jingmen, Hubei 448000 (CN); MEI, Zhengfang, Jingmen, Hubei 448000 (CN); HE, Wei, Jingmen, Hubei 448000 (CN); LIU, Jincheng, Jingmen, Hubei 448000 (CN)
(74) Representative: Berggren Oy
(86) International application number: PCT/CN2024/104601
(87) International publication number: WO 2025/039784

(57) **Abstract**

A temperature sensor, a battery, a battery pack and a health detecting method thereof, an evaluating method, and a monitoring system are provided. The data transmitting channel in the system is connected to the temperature collecting device, the stress collecting device and the data processing device respectively. The data processing device is configured to receive the temperature information collected by the temperature collecting device and the stress information collected by the stress collecting device, and determine the working health status of the battery according to temperature information and the stress information.

## Description

### CROSS REFERENCE TO RELATED APPLICATIONS

This application claims priority to and the benefit of Chinese Patent Application No. 202311131026.5 and 202311131033.5, filed on August 31, 2023, respectively, and Chinese Patent Application No. 202323632484.5, filed on December 27, 2023, Chinese Patent Application No. 202311063037.4, filed on August 21, 2023, the disclosure of which are incorporated herein by reference in their entireties.

### TECHNICAL FIELD

The present disclosure relates to the field of battery technology, and in particular, to a temperature sensor, a battery, a battery pack and a health detecting method thereof, an evaluating method, and a monitoring system.

### BACKGROUND

Lithium battery refers to the general term for batteries with lithium-ions intercalated compounds as the positive electrode material. Lithium battery has the advantages of small size, high energy density, long service life, and green environmental protection, and it is widely used in industries such as automobiles, electronic products, and energy storage systems.

### SUMMARY

However, unsafe conditions such as overcharge, over-discharge, short circuiting, extrusion, and overheating may occur during use of the lithium battery, which can easily risk the safety of the battery. Related technologies cannot effectively monitor and detect the battery, which affects the stability of the battery and reduces the safety of the battery.

In a first aspect, the present disclosure provides a monitoring system of a battery, the monitoring system includes:
a data transmitting channel, a temperature collecting device, a stress collecting device and a data processing device;
the data transmitting channel is connected to the temperature collecting device, the data transmitting channel is connected to the stress collecting device, and the data transmitting channel is connected to the data processing device; and
the temperature collecting device is configured to collect a temperature information of the battery, the stress collecting device is configured to collect a stress information of the battery, the data transmitting channel is configured to transmit the temperature information and the stress information to the data processing device, and the data processing device is configured to receive the temperature information and the stress information, and determine a working health status of the battery based on the temperature information and the stress information.

In a second aspect, the present disclosure provides a battery, the battery includes a first cell and a second cell, and the monitoring system of a battery in the first aspect described above.

In a third aspect, the present disclosure provides a power battery, the power battery includes:
a cell pack including a cell and tabs led out from the cell, and the tabs include a positive electrode tab and a negative electrode tab;
a top cover, in which soft connecting members are disposed on an inner side surface of the top cover, poles are disposed on an outer side surface of the top cover, and each of the poles is connected to each of the tabs through each of the soft connecting members; and
a resistance sensor including a sensor chip and a plurality of collecting wire harnesses, the sensor chip is disposed on the outer side surface of the top cover, a first end of each of the plurality of collecting wire harnesses is connected to the sensor chip, a second end of each of the plurality of collecting wire harnesses is respectively disposed on each of the tabs, each of the soft connecting members and each of the poles, and is respectively configured to collect an internal resistance between the positive electrode tab and the negative electrode tab, an internal resistance between each of the tabs and each of the soft connecting members, and an internal resistance between each of the soft connecting members and each of the poles, and the sensor chip detects a health status of the power battery based on the internal resistance between the positive electrode tab and the negative electrode tab, the internal resistance between each of the tabs and each of the soft connecting members, and the internal resistance between each of the soft connecting members and each of the poles.

In a fourth aspect, the present disclosure provides a health detecting method of a power battery, the power battery includes the power battery in the third aspect describe above, and the health detecting method includes:
collecting the internal resistance between the positive electrode tab and the negative electrode tab, the internal resistance between each of the tabs and each of the soft connecting members, and the internal resistance between each of the soft connecting members and each of the poles of the power battery through the resistance sensor; and
detecting the health status of the power battery according to the internal resistance between the positive electrode tab and the negative electrode tab, the internal resistance between each of the tabs and each of the soft connecting members, and the internal resistance between each of the soft connecting members and each of the poles of the power battery through the sensor chip of the resistance sensor.

In a fifth aspect, the present disclosure provides a power battery, the power battery includes one or more cells, an expansion force sensor, a temperature sensor, and an internal resistance sensor, and each of the expansion force sensor, the temperature sensor, and the internal resistance sensor is electrically connected to each of the one or more cells, in which:
the expansion force sensor is configured to collect one or more expansion forces of each of the one or more cells, and evaluate a health status of the power battery based on the one or more expansion forces;
the temperature sensor is configured to collect one or more temperatures of each of the one or more cells, and evaluate the health status of the power battery based on the one or more temperatures; and
the internal resistance sensor is configured to collect one or more internal resistances at one or more feature positions of each of the one or more cells, and evaluate the health status of the power battery based on the one or more internal resistances.

In a sixth aspect, the present disclosure provides a health evaluating method of a power battery, the power battery includes the power battery in the fifth aspect described above, and the health evaluating method includes:
collecting the one or more expansion forces of each of the one or more cells of the power battery through the expansion force sensor, and evaluating the health status of the power battery based on the one or more expansion forces;
collecting the one or more temperatures of each of the one or more cells through the temperature sensor, and evaluating the health status of the power battery based on the one or more temperatures;
collecting the one or more internal resistances at the one or more feature positions of each of the one or more cells through the internal resistance sensor, and evaluating the health status of the power battery based on the one or more internal resistances; and
further evaluating the health status of the power battery based on an evaluating result of the expansion force sensor, an evaluating result of the temperature sensor, and an evaluating result of the internal resistance sensor through a processor.

In a seventh aspect, the present disclosure provides a temperature sensor applied to a battery pack, in which the battery pack includes a smart chip and a cell, the temperature sensor is disposed in the cell and connected to the smart chip, the temperature sensor includes: a sensor bracket, a plurality of resistors disposed in the sensor bracket, a conductive line, and a converting and connecting line, and the plurality of resistors are connected in series through the conductive line; and
in which the plurality of resistors include a first resistor and a plurality of second resistors, a first channel is disposed between any two adjacent second resistors of the plurality of second resistors, first channels between two adjacent second resistors of the plurality of second resistors are connected to each other, one end of the converting and connecting line is connected to the first resistor, and another end of the converting and connecting line passes through each of the first channels, a conductive liquid and a thermal expansive fluid are further provided in the sensor bracket, a density of the conductive liquid is lower than a density of the thermal expansive fluid and the conductive liquid and the thermal expansive fluid are mutually incompatible, and the thermal expansive fluid pushes the conductive liquid to move in the first channels after being heated and expanded.

In an eighth aspect, the present disclosure provides a battery pack including a smart chip, a cell and the temperature sensor in the seventh aspect described above, in which the cell includes tabs, a cell pack and one or more pins, the cell pack is connected to each of one or more pins through each of the tabs, the sensor bracket and the one or more pins are disposed in a fitting manner, and the sensor bracket is connected to the smart chip.

### Beneficial effects

In the monitoring system of a battery and the battery provided by the present disclosure, the monitoring system of the battery includes a data transmitting channel, a temperature collecting device, a stress collecting device and a data processing device. The temperature information and the stress information of the battery are collected through the temperature collecting device and the stress collecting device respectively, and then the temperature information and the stress information are transmitted to the data processing device through the data transmitting channel. The data processing device determines the working health status of the battery based on the temperature information and the stress information. It can be seen that the implementation of the present disclosure can improve the efficiency and accuracy of information collection of the battery, improve the transmission efficiency of the battery information, and improve the accuracy of the working health status of the battery determined.

In the power battery and the health detecting method of the power battery provided by the present disclosure, the internal resistances at different positions of the battery cell pack is collected through multiple collecting wire harnesses, and the resistance changes inside the cell pack are detected in real time, thereby detecting the health status of the power battery and monitoring the safe status of the cell pack, so as to reduce the safety risks of the cell pack.

In the power battery and the health evaluating method of the power battery provided by the present disclosure, the power battery includes a cell, an expansion force sensor, a temperature sensor and an internal resistance sensor. The expansion force sensor, the temperature sensor and the internal resistance sensor are all electrically connected to the cell. The expansion force sensor is configured to collect the expansion force of the cell, and evaluate the health status of the power battery based on the expansion force. The temperature sensor is configured to collect the temperature of the cell, and evaluate the health status of the power battery based on the temperature. The internal resistance sensor is configured to collect the internal resistance at the feature position of the cell, and evaluate the health status of the power battery based on the internal resistance. Therefore, multiple sensors can be used to collect the internal resistance at the feature position, the expansion force, and the temperature of the cell to evaluate the health status of the battery, thereby monitoring the safety status of the cell in real time and reducing the safety risks of the cell.

In the temperature sensor and the battery pack provided by the present disclosure, a first resistor and a plurality of second resistors are disposed in the sensor bracket, a first channel is disposed between any two adjacent second resistors of the plurality of second resistors, and the first channels between two adjacent second resistors are connected to each other. One end of the conversion connecting line is connected to the first resistor, the other end of the conversion connecting line passes through the first channels, and the thermal expansive fluid is heated and expanded to push the conductive liquid to move in the first channels, which can convert the temperature signal in the cell into an electrical signal to realize temperature monitoring of the cell pack inside the cell and improve the safety and reliability of the battery pack. In addition, each component of the temperature sensor is disposed in the sensor bracket, so that various components of the temperature sensor can be protected against corrosion.

### BRIEF DESCRIPTION OF THE DRAWINGS

FIG. 1 is a schematic diagram of a structure of a monitoring system of a battery according to some embodiments of the present disclosure;
FIG. 2 is a schematic diagram of a structure of another monitoring system of a battery according to some embodiments of the present disclosure;
FIG. 3 is a schematic diagram of a structure of yet another monitoring system of a battery according to some embodiments of the present disclosure;
FIG. 4 is a schematic diagram of a structure of still another monitoring system of a battery according to some embodiments of the present disclosure;
FIG. 5 is a schematic diagram of a structure of still another monitoring system of a battery according to some embodiments of the present disclosure;
FIG. 6 is a schematic diagram of a structure of still another monitoring system of a battery according to some embodiments of the present disclosure;
FIG. 7 is a schematic diagram of a structure of a battery according to some embodiments of the present disclosure;
FIG. 8 is a schematic diagram of a structure of a power battery according to some embodiments of the present disclosure;
FIG. 9 is a schematic diagram of an outer side surface of a top cover of a power battery shown in FIG. 8;
FIG. 10 is a schematic flow diagram of a health detecting method of a power battery according to some embodiments of the present disclosure;
FIG. 11 is a schematic diagram of an internal structure of a power battery according to some embodiments of the present disclosure;
FIG. 12 is a schematic diagram of a side surface structure of a power battery shown in FIG. 11;
FIG. 13 is a schematic diagram of a front viewing structure of a power battery shown in FIG. 11;
FIG. 14 is a schematic diagram of another front viewing structure of a power battery shown in FIG. 11;
FIG. 15 is a schematic diagram of an outer side surface of a top cover of a power battery shown in FIG. 11;
FIG. 16 is a schematic flow diagram of a health evaluating method of a power battery according to some embodiments of the present disclosure;
FIG. 17 is a schematic diagram of a structure of a temperature sensor according to some embodiments of the present disclosure;
FIG. 18 is a schematic diagram of a structure of a circuit formed by a plurality of resistors in a temperature sensor according to some embodiments of the present disclosure;
FIG. 19 is a schematic diagram of a structure of a temperature sensor not covered by a bracket according to some embodiments of the present disclosure;
FIG. 20 is a schematic diagram of a cross-sectional structure of a temperature sensor in FIG. 3 according to some embodiments of the present disclosure;
FIG. 21 is a schematic bottom view of a temperature sensor in FIG. 3 according to some embodiments of the present disclosure;
FIG. 22 is a schematic diagram of a partial structure of a cell according to some embodiments of the present disclosure;
FIG. 23 is a schematic diagram of an overall structure inside a cell according to some embodiments of the present disclosure.

### Explanation of reference numerals:

Data transmitting channel 1, First section of the data transmitting channel 28, Second section of the data transmitting channel 29, Temperature collecting device 2, Stress collecting device 3, Data processing device 4, First cell 5, Second cell 6, Fixing element 7, First plane 8, Second plane 9, Third plane 10, Fourth plane 11, Cover plate 12, Wiring hole 13;

Power battery 18, Cell pack 25, Top cover 26, Resistance sensor 27, Cell 111, Tab 112, Positive electrode tab 112A, Negative electrode tab 112B, Soft connecting member 14, Pole 121, First soft connecting member 141, Second soft connecting member 142, Positive electrode pole 1211, Negative electrode pole 1212, Collecting wire harness 131, Sensor chip 24, First fixing area 1121, Collecting wire harness of a tab 1311, Collecting wire harness of a positive electrode tab 131A and 131C, Collecting wire harnesses of a negative electrode tab 131B and 131D, Collecting wire harness of a connecting member 1312, Collecting wire harness of a first collecting member 132A and 132C, Collecting wire harness of a second collecting member 132B and 132D, High-temperature adhesive 15, Collecting wire harness of a pole 1313, Collecting wire harness of a positive electrode pole 133A, Collecting wire harness of a negative electrode pole 133B, Through hole 122;

Expansion force sensor 100, Temperature sensor 200, Internal resistance sensor 300, First collecting end 101, First transmitting line 102, Second transmitting line 103, First processor 104, Second collecting end 105, Third transmitting line 106, Third collecting end 201, Fourth transmitting line 202, Second processor 203, First fixing portion 204, Second fixing portion 205, Third processor 16, Fourth collecting end 17, First collecting wire harness 132, Second collecting wire harness 133, Third collecting wire harness 134;

Temperature sensor 19, Tab 20, Cell pack 30, Pin 40, Housing 50, Cover plate 60, Lower plastic 70, Pin patch 80, Protective film 90, Sensor bracket 21, Resistor 22, Conductive line 23, Converting and connecting line 400, Conductive liquid 500, Thermal expansive fluid 600, Positive electrode line 700, Negative electrode line 800, First bracket 110, Second bracket 120, Third bracket 130, First resistor 210, Second resistor 220, Second channel 230, Side plate 51, Bottom plate 52.

### DETAILED DESCRIPTION

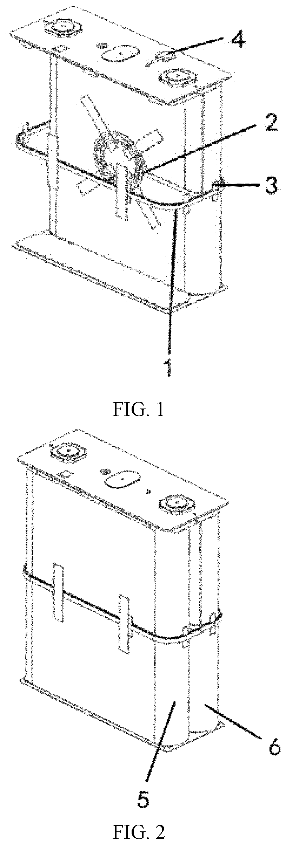

Referring to FIG. 1, FIG. 1 is a schematic diagram of a structure of a monitoring system of a battery according to some embodiments of the present disclosure.

The battery monitoring system can be applied to any battery that requires data collection (such as lithium-ion battery). As shown in FIG. 1, the monitoring system of a battery includes:
a data transmitting channel 1, a temperature collecting device 2, a stress collecting device 3 and a data processing device 4.

The data transmitting channel 1 is connected to the temperature collecting device 2, the data transmitting channel 1 is connected to the stress collecting device 3, and the data transmitting channel 1 is connected to the data processing device 4.

In some embodiments of the present disclosure, the monitoring system of the battery includes the data transmitting channel 1, the temperature collecting device 2, the stress collecting device 3 and the data processing device 4. The data transmitting channel 1 is connected to the temperature collecting device 2, the data transmitting channel 1 is connected to the stress collecting device 3, and the data transmitting channel 1 is connected to the data processing device 4. The data transmitting channel 1 may include an optical fiber, the temperature collecting device 2 may include a temperature sensor, the stress collecting device 3 may include an expansion force sensor, and the data processing device 4 may include a data processing chip or a data processing terminal.

In some embodiments of the present disclosure, the temperature sensor is configured to collect the temperature information of the battery. Optionally, the temperature sensor can continuously collect the temperature information of the battery, or it can also collect the temperature information of the battery at preset time intervals. The stress sensor is configured to collect the stress information of the battery. Optionally, the stress sensor can continuously collect the stress information of the battery, or it can collect the stress information of the battery at preset time intervals. The data transmitting channel is configured to transmit the temperature information and the stress information to the data processing device. The data transmitting channel may transmit the information in a manner including a wired transmission and a wireless transmission. The data processing device is configured to receive the temperature information and the stress information, and determine the working health status of the battery based on the temperature information and the stress information. The data processing device can determine the working health status of the battery in real time or at preset time intervals. When the stress conditions of the battery change, for example, the battery is extruded or damaged due to external mechanical reasons such as traffic accidents, and improper management of the battery voltage, such as improper charging and discharging processes or electronic component failure, changes will be caused in the temperature and the stress of the battery. In this case, the working health degree of the battery can be determined based on the information such as changing rate and changing degree of the temperature and stress of the battery, thereby improving the safety performance of the battery, which are not limited in the present disclosure.

It can be seen that by implementing the monitoring system of the battery in FIG. 1, the temperature information and the expansion force information of the battery can be collected through the temperature collecting device and the expansion force collecting device respectively, which improves the efficiency and accuracy of information collection of the battery. Then the temperature information and the expansion force information are transmitted through the data transmitting channel to the data processing device, and the working health status of the battery can be determined by the data processing device based on the temperature information and the expansion force information, which can improve the transmission efficiency of battery information and improve the accuracy of the determined working health status of the battery, thereby improving the using safety of the battery.

In an optional embodiment, as shown in FIG. 2, the battery includes a first cell 5 and a second cell 6, and the stress collecting device 3 includes the expansion force collecting device.

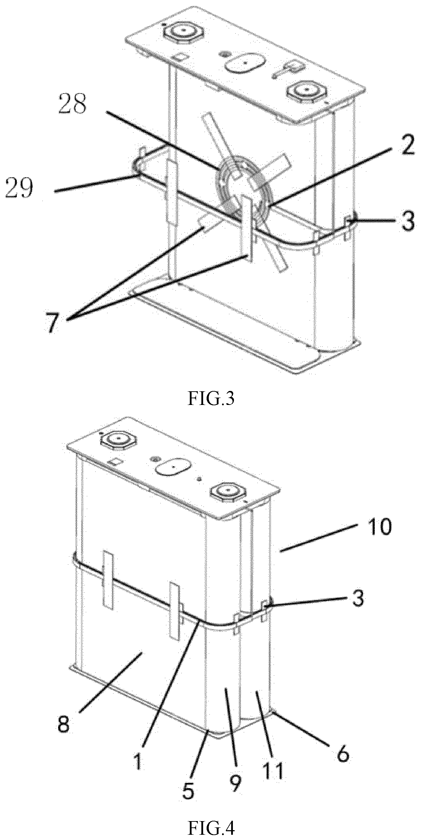

As shown in FIG.3, the data transmitting channel 1 includes a first section 28 and a second section 29 that are integrally formed. The first section 28 is fixed on the fitting surface between the first cell 5 and the second cell 6. The second section 29 is led out from the fitting surface between the first cell 5 and the second cell 6 and then is disposed around the periphery of the first cell 5 and the periphery of the second cell 6.

The temperature collecting device 2 is connected to the first section 28 and is fixed on the fitting surface between the first cell 5 and the second cell 6 through the fixing element 7. The expansion force collecting device is connected to the second section 29 and is fixed on the periphery of the first cell 5 and the periphery of the second cell 6 through the fixing element 7.

In this optional embodiment, as shown in FIG. 2, the battery includes the first cell 5 and the second cell 6, as shown in FIG. 3, the data transmitting channel includes the first section 28 and the second section 29 that are integrally formed. The first section 28 is fixed on the fitting surface between the first cell 5 and the second cell 6. The second section 29 is led out from the fitting surface between the first cell 5 and the second cell 6 and then is disposed around the periphery of the first cell 5 and the periphery of the second cell 6. The temperature collecting device 2 is connected to the first section 28, that is, the temperature collecting device 2 can monitor the temperature of the first cell 5 and the second cell 6 at the same time, so as to improve the efficiency of temperature collection. The temperature collecting device 2 is fixed on the fitting surface between the first cell 5 and the second cell 6 through the fixing element 7. The expansion force collecting device is connected to the second section 29 and is fixed on the periphery of the first cell 5 and the periphery of the second cell 6 through the fixing element 7.

In this optional embodiment, optionally, the first section of the data transmitting channel is fixed on the fitting surface between the first cell and the second cell in a circular shape, and the number of turns of the circular shape is at least one, and the temperature collecting device can be disposed on each turn of the circular shape. The radius of the smallest circle in the first section can be a quarter of the width of the large surface of the cell, and the center of the circle coincides with the intersection of the diagonal lines of the cell. The number of turns of the first section of the data transmitting channel can be three turns, and the temperature collecting device is fixed on the second turn. Optionally, the number of turns in the first section of the data transmitting channel can be 1 to 20 turns, and when the number of turns of the first section of the data transmitting channel is 20 turns, the first section can cover the fitting surface between the first cell and the second cell. At least one temperature collecting device is provided, and 4 temperature collecting devices can be provided. Optionally, 1 to 12 temperature collecting devices can be provided, the temperature collecting devices can be evenly spaced apart on the first section of the data transmitting channel, or the temperature collecting devices can be unevenly spaced apart on the first section of the data transmitting channel, which are not limited in the embodiments.

In this optional embodiment, optionally, the second section of the data transmitting channel is led out from the fitting surface between the first cell and the second cell and then is disposed around the periphery of the first cell and the periphery of the second cell. The number of winding turns of the second section is at least one turn. The number of turns of the second section of the data transmission channel led out from the fitting surface between the first cell and the second cell and then disposed around the periphery of the first cell and the second cell can be three turns. At least two expansion force collecting devices are provided, and 2 to 20 expansion force collecting devices can be provided, 8 expansion force collecting devices can be provided. The expansion force collecting devices can be evenly spaced apart on the second section of the data transmitting channel, or can be unevenly spaced apart on the second section of the data transmitting channel, which are not limited in the embodiments.

It can be seen that this optional embodiment can connect the temperature collecting device and the expansion force sensor through an integrated data transmitting channel, and can transmit the temperature information and the expansion force information, which can improve the transmission efficiency of battery information, thereby improving the determining efficiency of health status of the battery.

In another optional embodiment, as shown in FIG. 4, the first cell 5 includes a first plane 8 and a second plane 9 that are integrally formed. The plane where the first plane 8 is located is not parallel to the plane where the second plane 9 is located. The second cell 6 includes a third plane 10 and a fourth plane 11 that are integrally formed. The plane where the third plane 10 is located is not parallel to the plane where the fourth plane 11 is located.

The expansion force collecting device fixed on the periphery of the first cell 5 is disposed between the first cell 5 and the data transmitting channel 1 in a clamped manner, and the expansion force collecting device fixed on the periphery of the second cell 6 is disposed between the second cell 6 and the data transmitting channel 1 in a clamped manner.

At least two expansion force collecting devices are disposed on each of the first plane 8 and the third plane 10 respectively, and at least one expansion force collecting device is disposed on each of the second plane 9 and the fourth plane 11 respectively.

In this optional embodiment, as shown in FIG. 4, the first cell 5 includes the first plane 8 and the second plane 9 that are integrally formed. The plane where the first plane 8 is located is not parallel to the plane where the second plane 9 is located. The second cell 6 includes the third plane 10 and the fourth plane 11 that are integrally formed. The plane where the third plane 10 is located is not parallel to the plane where the fourth plane 11 is located. Optionally, the first plane 8 can be perpendicular to the second plane 9, the third plane 10 can be perpendicular to the fourth plane 11. The surface opposite to the first plane 8 and the surface opposite to the third plane 10 are fitted to form the fitting surface between the first cell 5 and the second cell 6.

In this optional embodiment, the expansion force collecting device fixed on the periphery of the first cell 5 is disposed between the first cell 5 and the data transmitting channel 1 in a clamped manner, and the expansion force collecting device fixed on the periphery of the second cell 6 is disposed between the second cell 6 and the data transmitting channel 1 in a clamped manner. At least two expansion force collecting devices are disposed on each of the first plane 8 and the third plane 10 respectively, and at least one expansion force collecting device is disposed on each of the second plane 9 and the fourth plane 11 respectively. At least one sensor is disposed on each of the plane opposite to the second plane 9 and the plane opposite to the fourth plane 11 respectively. At least one temperature sensor can be disposed on each of the first plane 8, the second plane 9, the third plane 10 and the fourth plane 11 respectively to collect the temperature of each surface of the cell respectively, which are not limited in the embodiments.

It can be seen that by implementing this optional embodiment, the expansion force sensors and temperature sensors can be disposed on multiple planes of the cell, so as to obtain the expansion force information and the temperature information of the cell, and improve the accuracy and reliability of the collected information of the cell, thereby improving the determining accuracy of the battery health status.

In yet another optional embodiment, the data processing device includes a data processing chip or a data processing terminal; and when the data processing device includes the data processing chip, the system further includes the data processing chip.

It can be seen that by implementing this optional embodiment, the temperature information and the expansion force information of the battery can be processed through the data processing chip, thereby improving the information processing efficiency.

In yet another optional embodiment, the stress information includes the expansion force information. The data processing device receiving the temperature information and the stress information, and determining the working health status of the battery based on the temperature information and the stress information includes following specific manner. The data processing device receives the temperature information and the expansion force information under each of the different working conditions. The data processing device analyzes the temperature information and the expansion force information under each working condition to obtain the temperature alarming threshold and the expansion force alarming threshold of the battery under each working condition. The data processing device receives the current temperature information and the current expansion force information of the battery under current working condition, and processes the current temperature information and the current expansion force information according to the remaining battery power of the battery, so as to obtain the temperature information processing result corresponding to the current temperature information and the expansion force information processing result corresponding to the current expansion force information. The data processing device compares the temperature information processing result with the temperature alarming threshold to obtain the first comparison result, and the data processing device compares the expansion force information processing result with the expansion force alarm threshold to obtain the second comparison result; and the data processing device determines the working health status of the battery based on the first comparison result and the second comparison result.

In this optional embodiment, optionally, different working conditions of the battery can include at least one of float charging condition, cyclic charging and discharging condition, half-cyclic charging and discharging condition, low-temperature working condition, and high-temperature working condition and the like. By analyzing the temperature information and the expansion force information under each working condition, the temperature alarming threshold and the expansion force alarming threshold of the battery under each working condition can be obtained. The normal temperature range and normal expansion force range of the battery under each working condition can also be obtained. The temperature failure threshold and the expansion force failure threshold of the battery under each working condition can be further obtained, which are not limited in the embodiments.

In this optional embodiment, optionally, the data processing device can receive the current temperature information and the current expansion force information of the battery under the current working condition in real time or in a preset time period. Processing the current temperature information and the current expansion force information according to the remaining power of the battery can include processing the current temperature information and the current expansion force information of the battery through a preset algorithm when the remaining power of the battery increases or decreases in a preset changing range, and the preset changing range can be 5% state of charge (SOC), which are not limited in the embodiments.

In this optional embodiment, optionally, the first comparison result can indicate whether the current temperature of the battery is greater than the temperature alarming threshold, and the second comparison result can indicate whether the current expansion force of the battery is greater than the expansion force alarming threshold. When the current temperature of the battery is greater than the temperature alarming threshold, the alarm of the battery temperature can be carried out. When the current expansion force is greater than the expansion force alarming threshold, the alarm of the battery expansion force can be carried out. The alarming manners include but are not limited to light signal feedback, voice signal feedback and text signal feedback. Taking the light signal feedback as an example, when the battery is normal, the light can be a green light, when the battery is alarming, the light can be a yellow light, and when the battery is abnormal, the light can be a red light, which are not limited in the embodiments.

It can be seen that by implementing this optional embodiment, the temperature information and the expansion force information of the battery can be analyzed, so as to determine the temperature alarming threshold and the expansion force alarming threshold of the battery under each working condition, and analyze the working health status of the battery based on the current temperature information and the current expansion force information of the battery under the current working condition, thereby improving the utilization of battery information, and improving the accuracy and reliability of analyzing the working health status of the battery.

In yet another optional embodiment, the data processing device is further configured to analyze the current temperature information and the current expansion force information of each of all batteries in the battery module, and obtain the first analysis result corresponding to the current temperature information of all batteries in the battery module and the second analysis result corresponds to the expansion force information of all batteries in the battery module. The battery module includes a plurality of batteries. The data processing device integrates the temperature alarming thresholds and the expansion alarm thresholds of all batteries in the battery module under current working condition to obtain the comprehensive temperature alarming threshold and the comprehensive expansion force alarming threshold of the battery module under the current working condition. The data processing device compares the first analysis result with the comprehensive temperature alarming threshold to obtain the third comparison result, and the data processing device compares the second analysis result with the comprehensive expansion force alarming threshold to obtain the fourth comparison result. The data processing device predicts the battery module life of the battery module based on the third comparison result and the fourth comparison result.

In this optional embodiment, the battery module can also be a battery cluster or a battery container, and the battery module includes a plurality of batteries. The first analysis result can include at least one of the average temperature information, the maximum temperature difference information and the temperature changing information in the battery module and the like. The second analysis result may include at least one of the average expansion force information, the maximum expansion force difference information, the expansion force changing information in the battery module and the like. The integration of the temperature alarming thresholds and the expansion force alarming thresholds of all batteries in the battery module under current working condition may include integrating the temperature alarm thresholds of all batteries in the battery module under the current working condition into the comprehensive temperature alarming threshold of the battery module under the current working condition, and integrating the expansion force alarming thresholds of all batteries in the module under the current working condition are into the comprehensive expansion force alarming threshold of the battery module under the current working condition. The third comparison result can indicate whether the temperature of the battery module is greater than the comprehensive temperature alarming threshold and the duration during which the temperature of the battery module is greater than the comprehensive temperature alarming threshold. The fourth comparison result can indicate whether the expansion force of the battery module is greater than the comprehensive expansion force alarming threshold and the duration during which the expansion force of the battery module is greater than the comprehensive expansion force alarming threshold, which are not limited in the embodiments.

It can be seen that by implementing this optional embodiment, the temperature information and the expansion force information of all batteries in the battery module can be analyzed, and the temperature thresholds and expansion force thresholds of all batteries in the battery module can be integrated, thereby predicting the battery module life of the battery module. The service life of the battery can be predicted based on the battery monitoring information, thereby reducing the chance of safety accidents due to battery aging and improving the using safety of the battery.

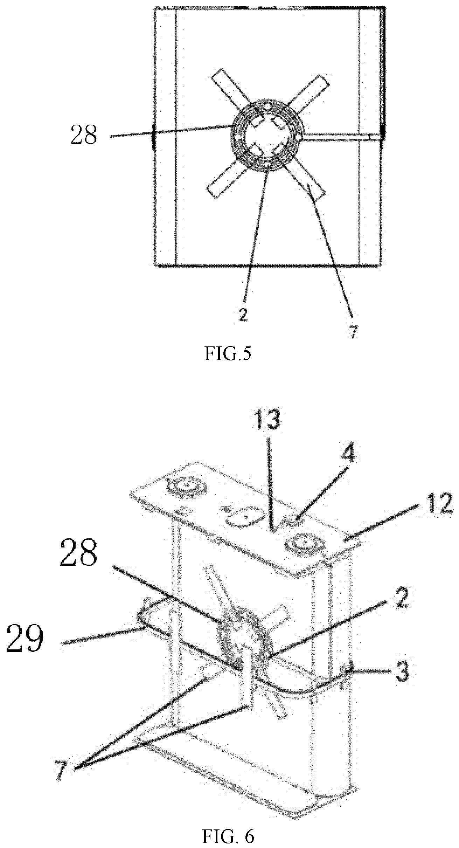

In yet another optional embodiment, as shown in FIG. 5, the first section 28 of the data transmitting channel is fixed on the fitting surface between the first cell and the second cell in a circular shape, and the number of circular turns in the first section is at least one.

The fixing element 7 does not cover the temperature collecting device 2, and the fixing element 7 includes an adhesive tape.

In this optional embodiment, the fixing element 7 does not cover the temperature collecting device 2, which can improve the accuracy of temperature collection by the temperature collecting device. The material of the fixing element 7 can be a high-temperature resistant material. Specifically, the fixing element 7 can be at least one of the silicone rubber tape, polytetrachloroethylene tape, polyimide tape and the like, which are not limited in the embodiments.

It can be seen that by implementing this optional embodiment, the data transmitting channel, the temperature collecting device and the expansion force collecting device can be fixed through the tape, which can reduce the difficulty of the process and improve the efficiency of the process operation.

In yet another optional embodiment, as shown in FIG. 6, the battery further includes a cover plate 12 covering the first cell and the second cell. At least one wiring hole 13 is disposed on the cover plate. When the data processing device 4 includes a data processing chip, the data processing device 4 is fixed on the cover plate 12. After the second section 29 of the data transmitting channel is disposed around the peripheries of the first cell and the second cell, the second section 29 is led out from the wiring hole 13 and is connected to the data processing device 4, and the material of the cover plate 12 includes an aluminum cover plate.

In this optional embodiment, when the data processing device includes a data processing terminal, the second section of the data transmitting channel is led out from the wiring hole and then is connected to the data processing terminal. The data processing terminal can exist independently from the battery, such as a vehicle terminal. The wiring hole can be a round hole located at the middle position between the liquid injecting hole and the positive electrode pole on the cover plate and with a diameter of 2 mm, or the wiring hole can be located at any position on the cover plate, which are not limited in the embodiments.

It can be seen that by implementing this optional embodiment, the temperature information and the expansion force information of the battery can be collected through the temperature collecting device and the expansion force collecting device respectively, which improves the efficiency and accuracy of information collecting of the battery. Then the temperature information and the expansion force information are transmitted through the data transmitting channel to the data processing device, and the working health status of the battery can be determined by the data processing device based on the temperature information and the expansion force information, which can improve the transmission efficiency of battery information and improve the accuracy of the determined working health status of the battery.

In yet another optional embodiment, a filling element is disposed between the cover plate and the first cell as well as the cover plate and the second cell, and the filling element is configured to seal and fix the first cell and the second cell; in which the filling element includes a sealant and/or a sealing ring.

In this optional embodiment, the filling element can include a sealant and/or a sealing ring, the sealant may be a mixed adhesive, such as adhesive by evenly mixing the AB adhesive, which is configured to assist in sealing and fixing. The filling position may be at the wiring hole on the cover plate and the surface of the cover plate.

It can be seen that by implementing this optional embodiment, the cover plate can be sealed and fixed through the filling element, thereby improving the overall stability and reliability of the battery.

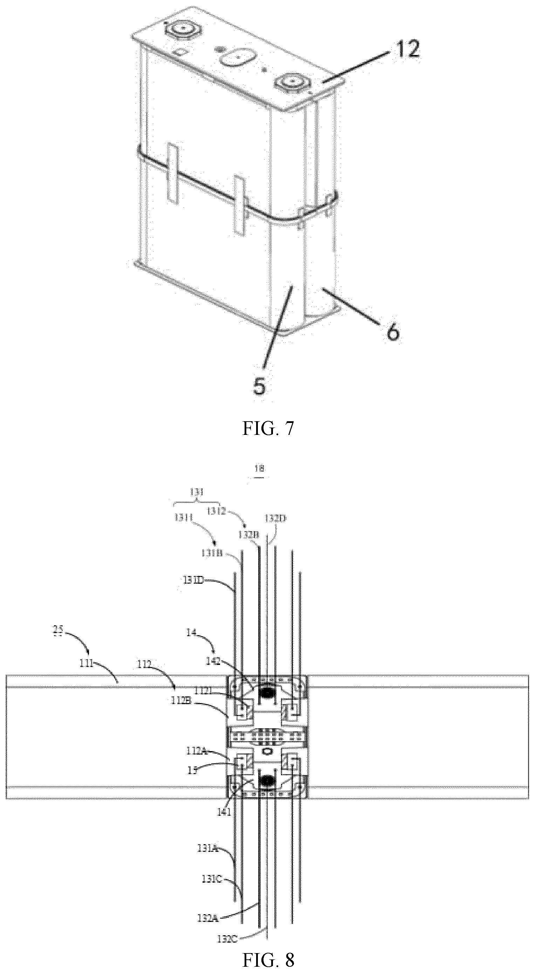

Referring to FIG. 7, FIG. 7 is a schematic diagram of a structure of a battery according to some embodiments of the present disclosure. The battery includes a first cell 5, a second cell 6 and a cover plate 12. The battery is any battery from which data needs to be collected (such as a lithium-ion battery), and the monitoring system of a battery described in any of the embodiment one is disposed in the battery. It should be noted that for the detailed description of the monitoring system of a battery, please refer to the specific description of the relevant content in embodiment one, which will not be described again in this embodiment.

The device embodiments described above are only illustrative. The modules described as separate components may or may not be physically separated.

The components shown as modules may or may not be physical modules, that is, the components may be located in one place, or they can be distributed to multiple network modules. Part or all of the modules can be selected according to actual requirements to achieve the purpose of the solutions of the embodiments. Those of ordinary skill in the art can understand and implement the embodiments without making any creative effort.

Through the detailed description of the above embodiments, those skilled in the art can clearly understand that each embodiment can be implemented by means of a software with a necessary general hardware platform, and it is apparent that the embodiments can also be implemented by a hardware. Based on the understanding described above, the above technical solutions can be embodied in the form of a software product in essence or in part that contribute to the existing technology. The computer software product can be stored in a computer-readable storage media, and the storage media includes read-only memory (ROM), random access memory (RAM), programmable read-only memory (PROM), erasable programmable read-only memory (EPROM), one-time programmable read-only memory (OTPROM), electronically-erasable programmable read-only memory (EEPROM), compact disc read-only memory (CD-ROM) or other optical disk storage, magnetic disk storage, tape storage , or any other computer-readable medium that can be used to carry or store data, in which the computer-readable storage medium may be nonvolatile or volatile.

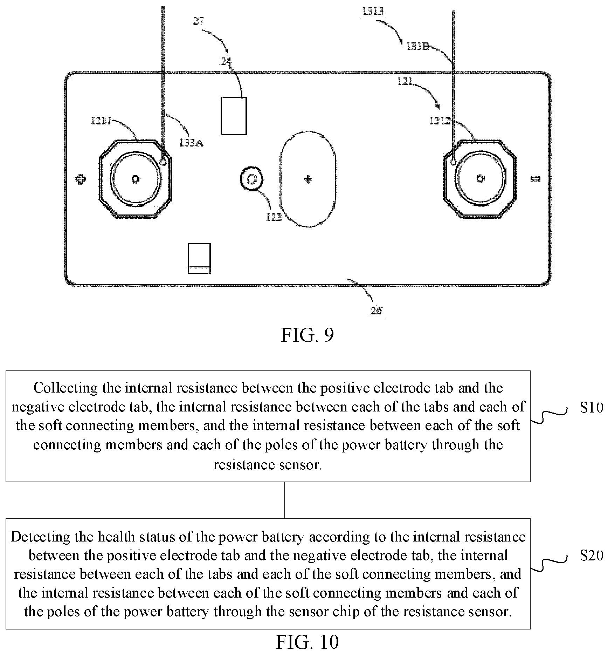

Refer to FIG. 8 and FIG. 9, FIG. 8 is a schematic diagram of a structure of a power battery according to some embodiments of the present disclosure; and FIG. 9 is a schematic diagram of an outer side surface of a top cover of a power battery shown in FIG. 8. As shown in FIG. 8 and FIG. 9, the power battery 18 includes a cell pack 25, a top cover 26 and a resistance sensor 27.

The cell pack 25 includes a cell 111 and tabs 112 led out from the cell 111.

In a specific embodiment, the power battery 18 is a dual-cell pack battery, that is, the power battery 18 includes two cell packs 25, and the manufacturing process of the cell packs 25 includes winding and lamination. The structures of the two cell packs 25 are identical. Unless otherwise specified, the structure of one of the cell packs 25 will be taken as an example to introduce the embodiments.

The tabs 112 include a positive electrode tab 112A and a negative electrode tab 112B. The positive electrode tab 112A and the negative electrode tab 112B are insulated by an insulating film. The welding manner of the tabs 112 is that: welding each of the positive electrode tab and the negative electrode tab of the wound or laminated cell pack 25 with a tipped welding head or a spiral welding head with a size of 6mm*16mm.

During normal use of the power battery 18, the positive electrode tab 112A and the negative electrode tab 112B are in an open circuiting state, and the internal resistance difference therebetween tends to be infinite. If a micro-short circuit occurs between the positive electrode tab 112A and the negative electrode tab 112B, then the internal resistance therebetween will be less than a preset internal resistance threshold. Micro-short circuit refers to the occurrence of tiny short circuits between internal cells or within the single cell in the power battery. This kind of short circuit may reduce the performance of the cell in a short period of time (weeks or months), causing a certain cell or the entire battery pack to be completely unusable. The structures of the positive electrode tab 112A and the negative electrode tab 112B are the same. Unless otherwise specified, the structure of one of the tabs 112 will be taken as an example to introduce the embodiments.

Soft connecting members 14 are disposed on the inner side surface of the top cover 26, and poles 121 are disposed on the outer side surface of the top cover 26. The pole 121 is connected to the tab 112 through the soft connecting member 14. The soft connecting member 14 can be made of conductive materials such as copper foil. Soft connecting member made of copper foil can effectively offset the impact and damage of the cell electrode due to vibration during use of the power battery.

In a specific embodiment, a through hole (not shown) may be disposed on the top cover 26.

The through hole penetrates the top cover 12. The pole 121 is disposed on the outer side surface of the top cover 26 and passes through the through hole to extend to the inner side surface of the top cover 26. One side surface of the soft connecting member 14 is fixed to the pole 121 on the inner side surface of the top cover 26, and the other side surface of the soft connecting member 14 away from the top cover 26 is fixed to the tab 112, thereby realizing the connection of the pole 121 and the tab 112.

If the connection and the fixation between the soft connecting member 14 and the pole 121 is normal, the internal resistance between the soft connecting member 14 and the pole 121 will be very small, which is equivalent to a short circuiting state therebetween. If the connection and the fixation between the soft connecting member 14 and the pole 121 is abnormal, the internal resistance therebetween will be very large, which is equivalent to an open circuiting state therebetween.

Similarly, if the connection and the fixation between the soft connecting member 14 and the tab 112 is normal, the internal resistance between the soft connecting member 14 and the tab 112 will be very small, which is equivalent to a short circuiting state therebetween. If the connection and the fixation between the soft connecting member 14 and the tab 112 is abnormal, the internal resistance therebetween will be very large, which is equivalent to an open circuiting state therebetween.

In a specific embodiment, the soft connecting members 14 include a first soft connecting member 141 and a second soft connecting member 142, and the poles 121 include a positive electrode pole 1211 and a negative electrode pole 1212. The positive electrode tab 112A is connected to the positive electrode pole 1211 through the first soft connecting member 141, and the negative electrode tab 112B is connected to the negative electrode pole 1212 through the second soft connecting member 142. Based on the above, that is, the positive electrode pole 1211 and the negative electrode pole 1212 are disposed on the outer side surface of the top cover 26 and pass through the through hole to extend to the inner side surface of the top cover 26. One side surface of the first soft connecting member 141 is fixed to the positive electrode pole 1211 on the inner side surface of the top cover 26, and the other side surface of the first soft connecting member 141 away from the top cover 26 is fixed to the positive electrode tab 112A, thereby realizing the connection of the positive electrode pole 1211 and the positive electrode tab 112A. One side surface of the second soft connecting member 142 is fixed to the negative electrode pole 1212 on the inner side surface of the top cover 26, and the other side surface of the second soft connecting member 142 away from the top cover 26 is fixed to the negative electrode tab 112B, thereby realizing the connection of the negative electrode pole 1212 and the negative electrode tab 112B.

The resistance sensor 27 includes a plurality of collecting wire harnesses 131 and a sensor chip 24. The sensor chip 24 is disposed on the outer side surface of the top cover 26. The first end of each of the plurality of collecting wire harnesses 131 is connected to the sensor chip 24. The second end of each of the plurality of collecting wire harnesses 131 is respectively disposed on the tab 112, the soft connecting member 14 and the pole 121, and is respectively configured to collect the internal resistance between the positive electrode tab 112A and the negative electrode tab 112B, the internal resistance between the tab 112 and the soft connecting member 14, and the internal resistance between the soft connecting member 14 and the pole 121. The sensor chip 24 detects the health status of the power battery 18 based on the internal resistances described above. Therefore, the present disclosure can collect the internal resistance between the tabs 112, the internal resistance between the tab 112 and the soft connecting member 14, and the internal resistance between the soft connecting member 14 and the pole 121 through a plurality of collecting wire harnesses 131, so as to detect the resistance changes at different positions inside the cell pack 25 in real time to detect the health status of the power battery 18 and monitor the safety status of the cell pack 25 , thereby reducing the safety risks of the cell pack 25.

Optionally, the tab 112 includes a first fixing area 1121, and the tab 112 is fixed to the soft connecting member 14 through the first fixing area 1121.

In a specific embodiment, the tab 112 and the soft connecting member 14 are fixedly connected through welding. The first fixing area 1121 of the tab 112 is the welding area of the tab 112. The soft connecting member 14 is also provided with a corresponding welding area. The two welding areas overlap and are fixed by welding.

Optionally, the plurality of collecting wire harnesses 131 include collecting wire harnesses of tabs 1311. The first end of each of the collecting wire harnesses of tabs 1311 is connected to the sensor chip 24, and the second end of each of the collecting wire harnesses of tabs 1311 is disposed on the area of the tab 112 except for the first fixing area 1121.

In a specific embodiment, the collecting wire harnesses of tabs 1311 include a collecting wire harness of a positive electrode tab 131A and a collecting wire harness of a negative electrode tab 131B. The first end of each of the collecting wire harness of the positive electrode tab 131A and the collecting wire harness of the negative electrode tab 131B is connected to the sensor chip 24. The second end of each of the collecting wire harness of the positive electrode tab 131A and the collecting wire harness of the negative electrode tab 131B is respectively disposed on the positive electrode tab 112A and the negative electrode tab 112B, and is configured to collect the internal resistance between the positive electrode tab 112A and the negative electrode tab 112B. Therefore, the internal resistance between the positive electrode tab 112A and the negative electrode tab 112B can be used to detect whether there is a fault of micro-short circuit between the positive electrode tab 112A and the negative electrode tab 112B.

Optionally, the soft connecting member 14 includes a second fixing area (not shown), and the soft connecting member 14 is fixed to the tab 112 through the second fixing area. If the tab 112 and the soft connecting member 14 are fixedly connected through welding. The second fixing area of the soft connecting member 14 is the welding area of the soft connecting member 14, and the two welding areas overlap and are fixed by welding.

Optionally, the plurality of collecting wire harnesses 131 further include collecting wire harnesses of collecting members 1312. The collecting wire harness of collecting members 1312 is disposed in the area of the soft connecting member 14 except for the second fixing area. The collecting wire harness of collecting members 1312 and the collecting wire harness of tabs 1311 collect the internal resistance between the tab 112 and the soft connecting member 14.

In a specific embodiment, the soft connecting member 14 includes a first soft connecting member 141 welded to the positive electrode tab 112A and a second soft connecting member 142 welded to the negative electrode tab 112B. The collecting wire harnesses of collecting members 1312 also includes a collecting wire harness of a first connecting member 132A and a collecting wire harness of a second connecting member 132B. The first end of each of the collecting wire harness of the first connecting member 132A and the collecting wire harness of the second connecting member 132B is connected to the sensor chip 24, and the second end of each of the collecting wire harness of the first connecting member 132A and the collecting wire harness of the second connecting member 132B is respectively connected to the first soft connecting member 141 and the second soft connecting member 142.

In a more specific embodiment, the collecting wire harnesses of tabs 1311 can further include a collecting wire harness of a positive electrode tab 131C and a collecting wire harness of a negative electrode tab 131D. The collecting wire harness of the first connecting member 132A and the collecting wire harness of the positive electrode tab 131C collect the internal resistance between the positive electrode tab 112A and the first soft connecting member 141.The collecting wire harness of the second connecting member 132B and the collecting wire harness of the negative electrode tab 131D collect the internal resistance between the negative electrode tab 112B and the second soft connecting member 142. Therefore, the present disclosure can determine whether there is a fault in the fixation between the positive electrode tab 112A and the first soft connecting member 141 through the internal resistance between the positive electrode tab 112A and the first soft connecting member 141, for example, whether there is a faulty welding or empty solder of the welding therebetween. Similarly, the present disclosure can determine whether there is a fault in the fixation between the negative electrode tab 112B and the second soft connecting member142 through the internal resistance between the negative electrode tab 112B and the second soft connecting member 142.

That is to say, in the collecting wire harnesses 131 disposed on the positive electrode tab 112A and the negative electrode tab 112B, different collecting wire harnesses are respectively used to detect whether there is a fault of micro-short circuit between the positive electrode tab 112A and the negative electrode tab 112B, detect whether there is a fixation fault between the positive electrode tab 112A and the first soft connecting member 141, and detect whether there is a fixation fault between the negative electrode tab 112B and the second soft connecting member 142. When detecting whether there is a fault of micro-short circuit between the positive electrode tab 112A and the negative electrode tab 112B, the collecting wire harness of the positive electrode tab 131A and the collecting wire harness of the negative electrode tab 131B are used to collect the internal resistance between the positive electrode tab 112A and the negative electrode tab 112B. When detecting whether there is a fixation fault between the positive electrode tab 112A and the first soft connecting member 141, and detecting whether there is a fixation fault between the negative electrode tab 112B and the second soft connecting member 142, the internal resistance between the positive electrode tab 112A and the first soft connecting member 141 are collected through the collecting wire harness of the positive electrode tab 131C and the collecting wire harness of the first connecting member 132A, and the internal resistance between the negative electrode tab 112B and the second soft connecting member 142 are collected through the collecting wire harness of the negative electrode tab 131D and the collecting wire harness of the second connecting member 132B. By using different collecting wire harnesses of tabs 1311 in different detecting applications, different collecting wire harnesses of tabs 1311 can be flexibly set according to different detecting applications, so that the layout can be reasonably arranged to improve the collection accuracy.

In a specific embodiment, the collecting wire harnesses of the positive electrode tab 131A and 131C may be symmetrical with respect to the center of the positive electrode tab 112A. Similarly, the collection wire harnesses of negative electrode tab 131B and 131D may be symmetrical with respect to the center of the negative electrode tab 112B. This allows the collecting wire harnesses 1311 of each tab to be reasonably laid out.

In a specific embodiment, considering that the faulty welding and empty solder between the tab 112 and the soft connecting member 14 generally occur in the middle position of the welding area, the collecting wire harness of the positive electrode tab 131C and the collecting wire harness of the negative electrode tab 131D can be disposed close to the welding area, and is respectively disposed at the middle position of the positive electrode tab 112A and the negative electrode tab 112B, that is, corresponding to the middle position of the welding area. Similarly, the collecting wire harness of the first connecting member 132A and the collecting wire harness of the second connecting member 132B are disposed close to the welding area and correspond to the middle position of the welding area.

It should be understood that, in consideration of simplifying the structure of the resistance sensor 27 and reducing costs, only one collecting wire harness of the positive electrode tab and only one collecting wire harness of the negative electrode tab can be provided. In this situation, the collecting wire harness of the positive electrode tab and the collecting wire harness of the negative electrode tab are respectively disposed at the middle position of the positive electrode tab 112A and the negative electrode tab 112B.

Optionally, the collecting wire harness of tabs 1311 is fixed with high-temperature adhesive 15. The high-temperature adhesive 15 can be brown high-temperature adhesive. For example, brown high-temperature tape with a size of 16mm*24mm can be used for fixation. The collecting wire harness of connecting members 1312 is fixed by the insulating adhesive (not shown) fixed to the tab 112 and the soft connecting member 14. The insulating adhesive is disposed on the welding area after the tab 112 and the soft connecting member 14 are welded to insulate the components from outside environment. By directly using the insulating adhesive disposed on the welding area after the tab 112 and the soft connecting member 14 are welded and fixed, there is no need to add additional fixing structures, thereby saving costs.

Optionally, the plurality of collecting wire harnesses further include collecting wire harnesses of poles 1313. The second end of the collecting wire harness of connecting member 1312 is disposed on a side surface of the soft connecting member 14 away from the inner side surface of the top cover 26, and the second end of the collecting wire harness of poles 1313 is disposed on the pole 121, the collecting wire harnesses of poles 1313 and the collecting wire harness of connecting members 1312 collect the internal resistance between the pole 121 and the soft connecting member 14.

In a specific embodiment, the collecting wire harnesses of poles 1313 can include a collecting wire harness of a positive electrode pole 133A and a collecting wire harness of a negative electrode pole 133B, the second end of each of the collecting wire harness of the positive electrode pole 133A and the collecting wire harness of the negative electrode pole 133B is respectively connected to the positive electrode pole 1211 and the negative electrode pole 1212.

The positive electrode pole 1211 and the first soft connecting member 141 are fixedly connected, and the two can be fixed by welding. The negative electrode pole 1212 and the second soft connecting member 142 are fixedly connected, and can also be fixed by welding. Therefore, the present disclosure can determine whether there is a fault in the fixation between the positive electrode pole 1211 and the first soft connecting member 141 through the internal resistance between the positive electrode pole 1211 and the first soft connecting member 141, for example, whether there is a faulty welding or empty solder of the welding therebetween. Similarly, the present disclosure can determine whether there is a fault in the fixation between the negative electrode pole 1212 and the second soft connecting 142 through the internal resistance between the negative electrode pole 1212 and the second soft connecting member 142, for example, whether there is a faulty welding or empty solder of the welding therebetween.

In a more specific embodiment, the collecting wire harnesses of connecting members 1312 may further include a collecting wire harness of the first collecting member 132C and a collecting wire harness of the second collecting member 132D, the second end of each of the collecting wire harness of the first collecting member 132C and the collecting wire harness of the second collecting member 132D is respectively connected to the first soft connecting member 141 and the second soft connecting member 142. Therefore, the present disclosure can collect the internal resistance between the first soft connecting member 141 and the positive electrode pole 1211 through the collecting wire harness of the first collecting member 132C and the collecting wire harness of the positive electrode pole 133A, so as to further determine whether there is a fault in the fixation between the first connecting member 141 and the positive electrode pole 1211, for example, whether there is a faulty welding or empty solder of the welding therebetween. Similarly, through the internal resistance between the second soft connecting member 142 and the negative electrode pole 1212 collected by the collecting wire harness of the second collecting member 132D and the collecting wire harness of the negative electrode pole 133B, the present disclosure can further determine whether there is a fault in the fixation between the second connecting member 142 and the negative electrode pole 1212.

That is to say, in the collecting wire harnesses disposed on the first soft connecting member 141 and the second soft connecting member 142, different collecting wire harnesses are used to detect whether there is a fixation fault between the positive electrode tab 112A and the first soft connecting member 141, detect whether there is a fixation fault between the negative electrode tab 112B and the second soft connecting member 142, and detect whether there is a fixation fault between the first soft connecting member 141 and the positive electrode pole 1211, and detect whether there is a fixation fault between the second soft connecting member 142 and the positive electrode pole 1211. When detecting whether there is a fixation fault between the positive electrode tab 112A and the first soft connecting member 141 and whether there is a fixation fault between the negative electrode tab 112B and the second soft connecting member 142, the collecting wire harness of the first connecting member 132A and the collecting wire harness of the second connecting member 132B can be used. When detecting whether there is a fixation fault between the first soft connecting member 141 and the positive electrode pole 1211 and detecting whether there is a fixation fault between the second soft connecting member 142 and the positive electrode pole 1211, the collecting wire harness of the first connecting member 132C and the collecting wire harness of the second connecting member 132D are used. Different collecting wire harnesses of connecting members 1312 can be flexibly set according to different detecting applications, so that the layout can be reasonably arranged to improve the collection accuracy.

In a specific embodiment, the collecting wire harness of the first connecting member 132A and the collecting wire harness of the second connecting member 132B are respectively disposed in the fixing area close to the positive electrode tab 112A and the negative electrode tab 112B, that is, the position of the welding area. The collecting wire harness of the first connecting member 132C and the collecting wire harness of the second connecting member 132D are respectively disposed in the fixing area close to the positive electrode pole 1211 and the negative electrode pole 1212, that is, the position of the welding area, so that the layout can be reasonably arranged to improve the collection accuracy. The collecting wire harness of the first connecting member 132A and the collecting wire harness of the second connecting member 132B are both arranged at a position on the soft connecting member 14 that does not coincide with the welding area, so as to avoid the implantation of the collecting wire harness of the first connecting member 132A and the collecting wire harness of the second connecting member 132B resulting in poor faulty welding or affecting the welding between the original collecting wire harness of connecting members and the tabs.

It should be understood that, in consideration of simplifying the structure of the resistance sensor 27 and reducing costs, only one collecting wire harness of the first connecting member and only one collecting wire harness of the second connecting member can be provided. In this situation, the collecting wire harness of the first connecting member and the collecting wire harness of the second connecting member are respectively disposed at the middle position of the first soft connecting member 141 and the second soft connecting member 142.

Optionally, the collecting wire harness of poles 1313 is fixed by dispensing adhesive.

Optionally, the resistance sensor 27 is an optical fiber sensor, and the collecting wire harness 131 is an optical fiber wire harness of the optical fiber sensor. The top cover 26 is provided with a through hole 122 penetrating the top cover 26, and the optical fiber wire harnesses corresponding to the tab 112 and the soft connecting member 14 can be led out to the outside of the top cover 26 through the through hole 122. It should be understood that the position of the through hole 122 is not limited.

Specifically, the optical fiber wire harness can be passed through the silicone sealing sleeve and then led out from the through hole 122 to connect to the sensor chip 24. The packaging method of the optical fiber wire harness can also use sealing rings and other forms. The sensor chip 24 can then be connected to the server through wireless or wired means. Therefore, after the server terminal receives the corresponding data (internal resistances at various positions of the cell pack), the server terminal can perform big data analysis to monitor whether problems such as micro-short circuit piercing the separator, short circuit, faulty welding, and empty solder occur in the cell pack 25.

Therefore, the present disclosure collects the internal resistance changes in the entire life cycle of the cell pack 25 by disposing optical fiber wire harnesses of the optical fiber sensor inside the cell pack 25, transmits the real-time collected internal resistance data to the external sensor chip 24, and sets the alarming value of invalid resistance through big data analysis, so as to monitor the safety status of the cell pack 25 in real time, reduce the safety risks of the cell pack 25 caused by short circuits, and troubleshoot problems such as empty solder and faulty welding during the manufacturing process of the cell pack 25.

Some embodiments of the present disclosure further provide a health detecting method of a power battery based on the power battery 18. Referring to FIG. 10, FIG. 10 is a health detecting method of a power battery according to some embodiments of the present disclosure. The power battery includes a power battery 18. As shown in FIG. 10, the health detecting method of the embodiments includes the following steps.

Step S10: collecting the internal resistance between the positive electrode tab and the negative electrode tab, the internal resistance between each of the tabs and each of the soft connecting members, and the internal resistance between each of the soft connecting members and each of the poles of the power battery through the resistance sensor.

Step S20: detecting the health status of the power battery according to the internal resistance between the positive electrode tab and the negative electrode tab, the internal resistance between each of the tabs and each of the soft connecting members, and the internal resistance between each of the soft connecting members and each of the poles of the power battery through the sensor chip of the resistance sensor.

In step S20, the internal resistance between the positive electrode tab and the negative electrode tab can be used to determine whether a short circuit fault occurs in the positive electrode tab and the negative electrode tab of the power battery.

The positive electrode tab and the negative electrode tab are insulated by an insulating film. During normal use of the power battery, the positive electrode tab and the negative electrode tab are in an open circuiting state, and the internal resistance difference therebetween tends to be infinite. If a micro-short circuit occurs between the positive electrode tab and the negative electrode tab, then the internal resistance therebetween will be less than a preset internal resistance threshold. Micro short circuit refers to the occurrence of tiny short circuits in power batteries between internal cells or within a single cell.

Step S20 specifically includes: if the internal resistance between the positive electrode tab and the negative electrode tab is less than a first internal resistance threshold, determining that a short circuit fault occurs between the positive electrode tab and the negative electrode tab of the power battery. On the contrary, if the internal resistance between the positive electrode tab and the negative electrode tab is greater than or equal to the first internal resistance threshold, determining that there is no short circuit fault between the positive electrode tab and the negative electrode tab of the power battery.

In step S20, the internal resistance between the tab and the soft connecting member can also be used to determine whether a fault in the fixation between the electrode tab and the soft connecting member occurs.

The soft connecting member includes a first soft connecting member and a second soft connecting member. The first soft connecting member is fixed to the positive electrode tab, and the second soft connecting member is fixed to the negative electrode tab, for example, by welding.

If the connection and fixation between the soft connecting member and the tab is normal, the internal resistance between the soft connecting member and the tab will be very small, which is equivalent to a short circuiting state therebetween. If the connection and fixation between the soft connecting member and the tab is abnormal, the internal resistance therebetween will be very large, which is equivalent to an open circuiting state therebetween.

Step S20 specifically includes: if the internal resistance between each of the tabs and each of the soft connecting members is greater than a second internal resistance threshold, determining that a fault occurs in the fixation between each of the tabs and each of the soft connecting members. Specifically, if the internal resistance between the positive electrode tab and the corresponding first soft connecting member is greater than the second internal resistance threshold, it is determined that a fault occurs in the fixation between the positive electrode tab and the first soft connecting member, such as faulty welding or empty solder and the like. If the internal resistance between the negative electrode tab and the corresponding second soft connecting member is greater than the second internal resistance threshold, it is determined that a fault occurs in the fixation between the negative electrode tab and the second soft connecting member, and vice versa.

In step S20, the relationship of the internal resistance between the soft connecting member and the pole can also be used to determine whether a fault occurs in the fixation between the soft connecting member and the pole.

If the connection and the fixation between the soft connecting member and the pole is normal, the internal resistance between the soft connecting member and the pole will be very small, which is equivalent to a short circuiting state therebetween. If the connection and fixation between the soft connecting member and the pole is abnormal, the internal resistance therebetween will be very large, which is equivalent to an open circuiting state therebetween.

Step S20 specifically includes: if the internal resistance between each of the soft connecting members and each of the poles is greater than the second internal resistance threshold, determining that a fault occurs in the fixation between each of the soft connecting members and each of the poles. Specifically, if the internal resistance between the first soft connecting member and the positive electrode pole is greater than the second internal resistance threshold, it is determined that a fault occurs in the fixation between the first soft connecting member and the positive electrode pole, such as a faulty welding or empty solder and the like. If the internal resistance between the second soft connecting member and the negative electrode pole is greater than the second internal resistance threshold, it is determined that a fault occurs in the fixation between the second soft connecting member and the negative electrode pole, such as a faulty welding or empty solder and the like, and vice versa.

To sum up, the present disclosure introduces a power battery and a health detecting method of a power battery. The power battery includes: a cell pack, a top cover and a resistance sensor. The cell pack includes a cell and tabs led out from the cell, and the tabs include a positive electrode tab and a negative electrode tab. Soft connecting members are disposed on the inner side surface of the top cover. Poles are disposed on the outer side surface of the top cover, and the poles are connected to the tabs through the soft connecting members. The resistance sensor includes a sensor chip and a plurality of collecting wire harnesses, and the sensor chip is disposed on the outer side surface of the top cover. The first end of each of the plurality of collecting wire harnesses is connected to the sensor chip, and the second end of each of the plurality of collecting wire harnesses is respectively disposed on the tab, the soft connecting member and the pole, so as to collect the internal resistance between the positive electrode tab and the negative electrode tab, the internal resistance between the tab and the soft connecting member, and the internal resistance between the soft connecting member and the pole. The sensor chip detects the health status of the power battery based on the internal resistances described above. Therefore, the internal resistance between the tabs, between the tab and the soft connecting member, and between the soft connecting member and the pole can be collected through a plurality of collecting wire harnesses to detect the resistance changes inside the cell pack in real time, so as to monitor the safety status of the cell pack, thereby reducing the safety risks of the cell pack.

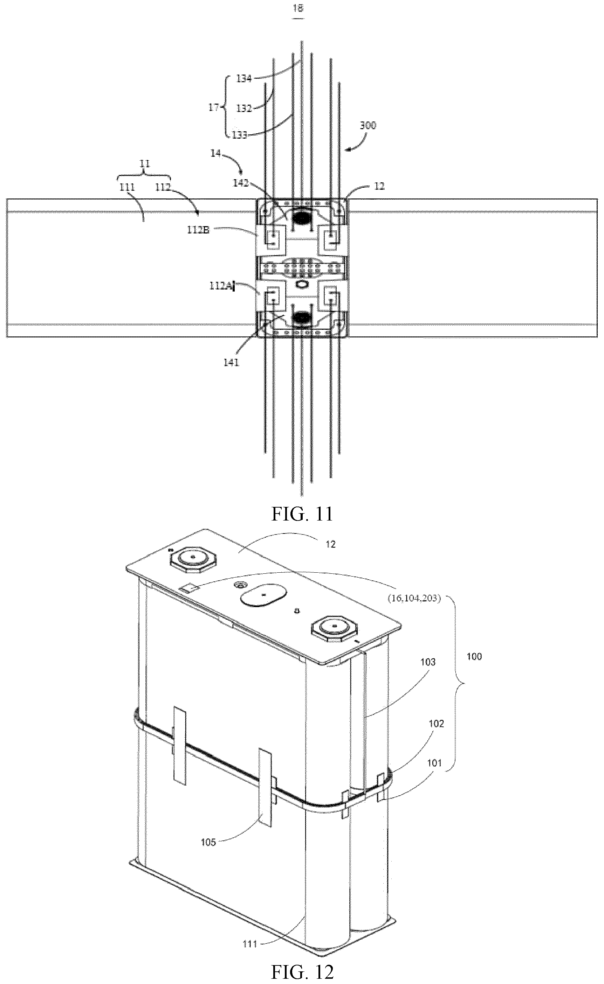

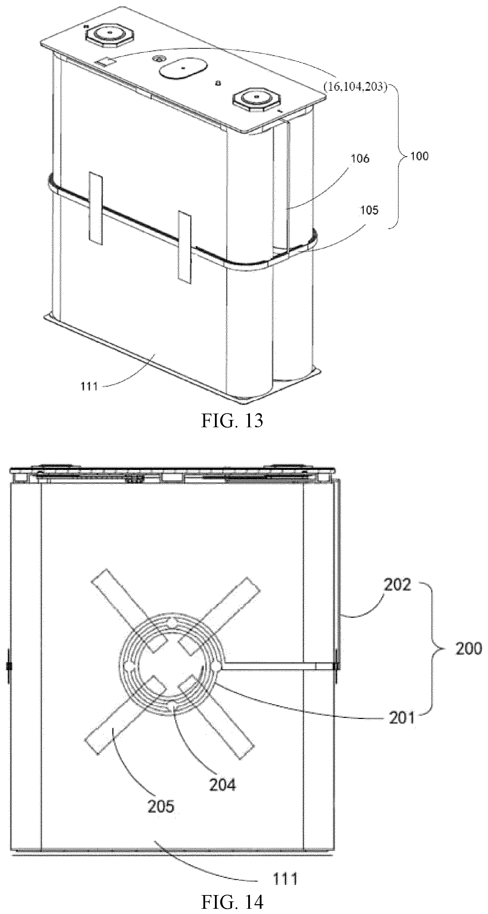

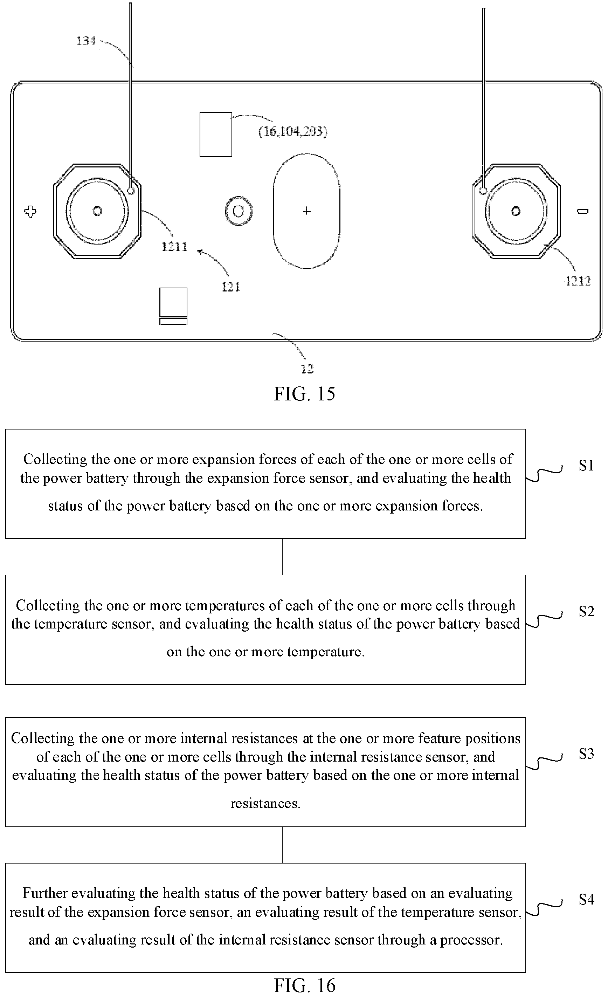

Referring to FIG. 11 to FIG. 15, FIG. 11 is a schematic diagram of an internal structure of a power battery according to some embodiments of the present disclosure; FIG. 12 is a schematic diagram of a side structure of a power battery shown in FIG. 11; FIG. 13 is a schematic diagram of a front viewing structure of a power battery shown in FIG. 1; FIG. 14 is a schematic diagram of another front viewing structure of a power battery shown in FIG. 11; FIG. 15 is a schematic diagram of an outer side surface of a top cover of a power battery shown in FIG. 11. The power battery 18 includes at least one cell pack 25, an expansion force sensor 100, a temperature sensor 200 and an internal resistance sensor 300. The cell pack 25 includes a cell 111 and tabs 112 led out from the cell 111. The expansion force sensor 100, the temperature sensor 200 and the internal resistance sensor 300 are all electrically connected to the cell 111.

Depending on the number of cell packs 25, the power battery 18 can be a single-cell pack battery, a dual-cell pack battery, or a multi-cell pack battery. The manufacturing process of the cell 25 includes winding and lamination. Unless otherwise specified, the structure of one of the cell packs 25 will be taken as an example to introduce the embodiments.

The expansion force sensor 100 is configured to collect the expansion force of the cell 111 and evaluate the health status of the power battery 18 based on the expansion force. The temperature sensor 200 is configured to collect the temperature of the cell 111 and evaluate the health status of the power battery 18 based on the temperature. The internal resistance sensor 300 is configured to collect the internal resistance at at least one feature position of the cell 111, and evaluate the health status of the power battery 18 based on the internal resistance. Therefore, multiple sensors can be used to collect the internal resistance at the feature position, the expansion force, and the temperature of the cell 111 to evaluate the health status of the power battery 18, thereby monitoring the safety status of the cell 111 in real time and reducing the safety risks of the cell 111.

Optionally, the power battery 18 includes a housing (not shown), and the cell 111 is disposed in the housing. The housing can be a wound square aluminum housing, a cylinder, a laminated square aluminum housing, and the like. The housing serving as a protective shell for the cell 111 is generally in close contact with the cell 111, that is, the cell 111 is in contact with the inner side wall of the housing. When the cell 111 expands due to heating or other reasons of the cell, the cell 111 squeezes the housing. In the embodiments, the expansion force of the cell 111 is collected by collecting the squeezing force. Specifically, the expansion force sensor 100 includes a plurality of first collecting ends 101, a first transmitting line 102, a second transmitting line 103 and a first processor 104. The plurality of first collecting ends 101 are disposed between the cell 111 and the housing, and are located at multiple positions of the cell 111 to collect the pressures at multiple positions between the cell 111 and the housing after the expansion of the cell 111 to serve as the expansion force. The first transmitting line 102 is connected to the plurality of first collecting ends 101 to obtain the expansion force collected by the plurality of first collecting ends 101. One end of the second transmitting line 103 is connected to the first transmitting line 102, and the other end is connected to the first processor 104, so as to transmit multiple expansion forces obtained by the first transmitting line 102 to the first processor 104.

In a specific embodiment, the expansion force sensor 100 can be an optical fiber sensor, which has a silica optical fiber layer inside and a polymer material coating of polyethyleneimine outside. The first collecting end 101 can have a patched structure and is attached to the outer side wall of the cell 111. The first transmitting line 102 is wound around the outer side wall of the cell 111, and the first collecting end 101 is disposed between the outer side wall of the cell 111 and the first transmitting line 102.

On the one hand, the first transmitting line 102 plays the role of transmitting the expansion forces collected by the first collecting ends 101, and on the other hand, the first transmitting line 102 can also fix the first collecting ends 101. In order to fix the first transmitting line 102, a fixing piece, such as a bonding adhesive and the like, is further provided to fix the first transmitting line 102 on the outer side wall of the cell 111.

The description introduced above is to collect the expansion force of the cell 111 by collecting the squeezing force between the cell 111 and the housing. In other embodiments, the expansion force of the cell 111 can also be collected through the squeezing force of the cell on the collecting end when the cell 111 expands. Specifically, referring to FIG. 13, the expansion force sensor 100 further includes a second collecting end 105, a third transmitting line 106 and a first processor 104. The second collecting end 105 is a collecting coil, which is wound around the outer periphery of the cell 111 and has elasticity. The second collecting end 105 is configured to collect the elastic force of the collecting coil stretched caused by the expansion of the cell 111, and the elastic force serves as the expansion force. One end of the third transmitting line 106 is connected to the collecting coil, and the other end is connected to the first processor 104, so as to transmit the expansion force collected by the collecting coil to the first processor 104. It can be understood that the third transmitting line 106 has the same structure and function as the second transmitting line 103.

In a specific embodiment, the elastic force of the stretched collecting coil can be positively correlated with the resistance of the collecting coil, that is, the second collecting end 105 collects the resistance changing value when the collecting coil elastically deforms, and the resistance changing value is transmitted to the first processor 104 through the third transmitting line 106.

Optionally, the temperature sensor 200 can be a thermocouple sensor, inside of which a thermocouple is provided.

The temperature sensor 200 includes a third collecting end 201, a fourth transmitting line 202 and a second processor 203. The third collecting end 201 is a spiral line and is disposed on the side surface of the cell 111 to collect the temperatures at multiple positions on the side surface. One end of the fourth transmitting line 202 is connected to the third collecting end 201, and the other end is connected to the second processor 203 for transmitting the temperatures at multiple positions to the second processor 203. By designing the third collecting end 201 to have a spiral shape, the contact surface between the third collecting end 201 and the cell 111 can be increased, and the error due to few points are taken during the temperature measuring process can be reduced. The coiling interval inside the spiral line can be adjusted according to the detecting requirements. For example, when the side surface area of the measured cell is small, the interval can be set smaller to ensure the number of collected temperature, and when the side surface area of the measured cell is larger, the interval can be set larger to ensure that the temperature of a larger position range of the cell can be collected.

At least one first fixing portion 204 and at least one second fixing portion 205 are disposed on the spiral line for fixing the spiral line. A plurality of first fixing portions 204 are provided and are configured to fix the single turn of the spiral line in the winding direction of the spiral line. A plurality of second fixing portions 205 are also provided, and are configured to entirely fix the spiral line at different positions.

Optionally, one cell 111 is provided, that is, the cell pack 25 is a single-cell cell pack. In this structure, the third collecting end 201 is disposed on the side surface of the cell 111 with the largest area. When the cell 111 has a cuboid structure or a structure similar to a cuboid, the cell includes two side surfaces with the largest area, and then the third collecting ends 201 can be disposed on two side surfaces.

Optionally, at least two cells 111 are provided, that is, the cell pack 25 is a dual-cell cell pack. In this structure, the third collecting end 201 is disposed between two adjacent cells 111, and is connected to the side surface of each of two adjacent cells 111.

Optionally, the power battery 18 includes tabs 112 electrically connected to the cell 111. The tabs 112 include a positive electrode tab 112A and a negative electrode tab 112B, and the positive electrode tab 112A and the negative electrode tab 112B are insulated by an insulating film. The welding manner of the tabs 112 is that: welding each of the positive electrode tab and the negative electrode tab of the wound or laminated cell pack 25 with a tipped welding head or a spiral welding head with a size of 6mm*16mm.

During normal use of the power battery 18, the positive electrode tab 112A and the negative electrode tab 112B are in an open circuiting state, and the internal resistance difference therebetween tends to be infinite. If micro-short circuit occurs between the positive electrode tab 112A and the negative electrode tab 112B, then the internal resistance therebetween will be less than a preset internal resistance threshold. Micro-short circuit refers to the occurrence of tiny short circuits between internal cells or within the single cell in the power battery This kind of short circuit may reduce the performance of the cell in a short period of time (weeks or months), causing a certain cell or the entire battery pack to be completely unusable. The structures of the positive electrode tab 112A and the negative electrode tab 112B are the same. Unless otherwise specified, the structure of one of the tabs 112 will be taken as an example to introduce the embodiments.

The internal resistance sensor 300 may be a galvanic sensor, inside of which a galvanic couple is provided. The internal resistance sensor 300 includes a third processor 16 and a fourth collecting end 17. The fourth collecting end 17 includes first collecting wire harnesses 132, one end of each of the first collecting wire harnesses is connected to the positive electrode tab 112A and the negative electrode tab 112B respectively, and the other end is connected to the third processor 16 for transmitting the collected internal resistance between the positive electrode tab 112A and the negative electrode tab 112B to the third processor 16. Therefore, the third processor 16 evaluates the occurrence of a micro-short circuit between the positive electrode tab 112A and the negative electrode tab 112B through the internal resistance value between the positive electrode tab 112A and the negative electrode tab 112B.

The power battery 18 includes a top cover 26. Soft connecting members 14 are disposed on the inner side surface of the top cover 26, and poles 121 are disposed on the outer side surface of the top cover 26. The pole 121 is connected to the tab 112 through the soft connecting member 14. The soft connecting members 14 can be made of conductive materials such as copper foil. Soft connecting member made of copper foil can effectively offset the impact and damage of the cell electrode due to vibration during use of the power battery.

In a specific embodiment, a through hole (not shown) may be provided on the top cover 26, and the through hole penetrates the top cover 26. The pole 121 is disposed on the outer surface of the top cover 26 and passes through the through hole to extend to the inner side surface of the top cover 26. One side surface of the soft connecting member 14 is fixed to the pole 121 on the inner side surface of the top cover 26, and the other side surface of the soft connecting member 14 away from the top cover 26 is fixed to the tab 112, thereby realizing the connection between the pole 121 and the tab 112.

If the connection and the fixation between the soft connecting member 14 and the pole 121 is normal, the difference between the internal resistance of the soft connecting member 14 and the internal resistance of the pole 121 will be very small, which is equivalent to a short circuiting state therebetween. If the connection and the fixation between the soft connecting member 14 and the pole is abnormal, the difference in the internal resistance therebetween will be very large, which is equivalent to an open circuiting state therebetween. Similarly, if the connection and fixation between the soft connecting member 14 and the tab 112 is normal, the difference between the internal resistance of the soft connecting member 14 and the internal resistance of the tab 112 will be very small, which is equivalent to a short circuiting state therebetween. If the connection and fixation between the soft connecting member 14 and the tab 112 is abnormal, the difference in the internal resistance therebetween will be very large, which is equivalent to an open circuiting state therebetween.

In a specific embodiment, the soft connecting members 14 include a first soft connecting member 141 and a second soft connecting member 142, and the poles 121 include a positive electrode pole 1211 and a negative electrode pole 1212. The positive electrode tab 112A is connected to the positive electrode pole 1211 through the first soft connecting member 141, and the negative electrode tab 112B is connected to the negative electrode pole 1212 through the second soft connecting member 142.

Optionally, the tab 112 and the soft connecting member 14 are fixedly connected through welding. The pole 121 and the soft connecting member 14 are also fixedly connected by welding.

Optionally, the fourth collecting end 17 further includes second collecting wire harnesses 133. One end of each of the second collecting wire harnesses 133 is connected to the soft connecting member 14, and the other end is connected to the third processor 16. The second collecting wire harness 133 is configured to collect the internal resistance between the tab 112 and the soft connecting member 14 together with the first collecting wire harness 132 and transmit the internal resistance to the third processor 16. Therefore, the difference in the internal resistance between the tab 112 and the soft connecting member 14 can be used to determine whether there is a fault in the welding between the tab 112 and the soft connecting member 14, such as whether there is faulty welding, empty solder of the welding therebetween.

Optionally, the fourth collecting end 17 further includes third collecting wire harnesses 134. One end of each of the third collecting wire harnesses 134 is connected to the pole 121, and the other end is connected to the third processor 16. The third collecting wire harness 134 is configured to collect the internal resistance between the soft connecting member 14 and the pole 121 together with the second collecting wire harness 133 and transmit the internal resistance to the third processor 16. Therefore, the difference in the internal resistance between the pole 121 and the soft connecting member 14 can be used to determine whether there is a fault in the welding between the pole 121 and the soft connecting member 14, such as whether there is faulty welding, empty solder of the welding therebetween.

Therefore, the present disclosure can evaluate the health status of the battery by collecting the internal resistance at the feature position, the expansion force, and the temperature of the cell through multiple sensors, thereby monitoring the safety status of the cell in real time and reducing the safety risks of the cell.

Some embodiments of the present disclosure further provide a health evaluating method of a power battery based on the power battery 18. Referring to FIG. 16, FIG. 16 is a schematic flow diagram of a health evaluating method of a power battery according to some embodiments of the present disclosure. The power battery includes a power battery 18. As shown in FIG. 16, the health evaluating method of the embodiments includes the following steps.

Step S1: collecting the one or more expansion forces of each of the one or more cells of the power battery through the expansion force sensor, and evaluating the health status of the power battery based on the one or more expansion forces.

This step can determine whether the expansion force is greater than the expansion force threshold, and if so, evaluating that the health status of the power battery is abnormal.

In one embodiment, the pressures at multiple positions between the cell and the housing after the expansion of the cell are collected through the expansion force sensor and served as the expansion forces, and health status of the power battery is evaluated based on the plurality of expansion forces. Specifically, in one manner, the average of a plurality of expansion forces can be taken as the expansion force of the battery, and then it is determined whether the average expansion force is greater than the expansion force threshold. If it is greater than the expansion force threshold, then it is evaluated that the health status of the power battery is abnormal. In another manner, the maximum value of the plurality of expansion forces can be used as the expansion force of the battery, and then it can be determined whether the expansion force with the maximum value is greater than the expansion force threshold. If it is greater than the expansion force threshold, then it is evaluated that the health status of the power battery is abnormal.

In another embodiment, the expansion force sensor has elasticity. The expansion force sensor in this step collects the elastic force generated by the sensor after the expansion of the cell, and the elastic force is served as the expansion force, and it is determined whether the average expansion force is greater than the expansion force threshold. If it is greater than the expansion force threshold, then it is evaluated that the health status of the power battery is abnormal. The elastic force of the expansion force sensor can be related to the changes in its own resistance, so that the expansion force can be obtained by collecting the changes of the resistance.

In addition, this step can further collect the thickness of the cell, the remaining amount of electrolyte, and changes in gas production through the expansion force sensor.

Step S2: collecting the one or more temperatures of each of the one or more cells through the temperature sensor, and evaluating the health status of the power battery based on the one or more temperature. This step can determine whether the temperature is greater than the temperature threshold, and if it is greater than the temperature threshold, then it is evaluated that the health status of the power battery is abnormal.

In this step, the temperature sensor can be used to collect temperatures at multiple positions on the side surface of the cell, and the health status of the power battery can be evaluated based on the multiple temperatures.

Specifically, in one manner, the average value of a plurality of temperatures can be taken as the temperature of the battery, and then it is determined whether the average temperature is greater than the temperature threshold. If it is greater than the temperature threshold, then it is evaluated that the health status of the power battery is abnormal. In another manner, the maximum value of the plurality of temperatures can be used as the temperature of the battery, and then it can be determined whether the temperature with the maximum value is greater than the temperature threshold. If it is greater than the temperature threshold, then it is evaluated that the health status of the power battery is abnormal.

Step S3: collecting the one or more internal resistances at the one or more feature positions of each of the one or more cells through the internal resistance sensor, and evaluating the health status of the power battery based on the one or more internal resistances.

The feature position points may include the positions at the tab, the soft connecting member, and the pole. The internal resistance between the positive electrode tab and the negative electrode tab, the internal resistance between the tab and the soft connecting member, and the internal resistance between the pole and the soft connecting member can be collected respectively to evaluate the health status of the power battery.

Specifically, if the difference between the internal resistance of the positive electrode tab and the internal resistance of the negative electrode tab is less than the first internal resistance threshold, it is determined that a short circuit fault occurs between the positive electrode tab and the negative electrode tab of the power battery, and the health status of the power battery is abnormal. If the difference between the internal resistance of the tab and the internal resistance of the corresponding soft connecting member is greater than the second internal resistance threshold, it is determined that a fault occurs in the fixation between the tab and the soft connecting member, such as a faulty welding or empty solder and the like, and the health status of the power battery is abnormal. If the difference between the internal resistance of the soft connecting member and the internal resistance of the pole is greater than the second internal resistance threshold, determining that a fault occurs in the fixation between the soft connecting member and the pol, such as faulty welding or empty solder and the like, and the health status of the power battery is abnormal.

Step S4: further evaluating the health status of the power battery based on an evaluating result of the expansion force sensor, an evaluating result of the temperature sensor, and an evaluating result of the internal resistance sensor through a processor.

Specifically, the processor can further evaluate the health status of the power battery based on the evaluating results of the sensors. The sensor only simply evaluates that the corresponding parameter is abnormal, which leads to abnormal health status of the power battery, but the sensor does not perform a comprehensive evaluation. This step can comprehensively determine the health status of the battery by summarizing the evaluating results of each sensor. Specifically, the health status of the power battery can be divided into different levels. Each kind of parameter corresponds to a health level. For example, the expansion force corresponds to the level-one health level of the power battery, the temperature corresponds to the level-two health level, and the internal resistance at the feature position corresponds to the level-three health level. Different health levels correspond to different processing emergencies.

The processor analyzes the evaluating results of the sensors to obtain the corresponding health level of the power battery. If there are multiple health levels, the highest health level is used for processing. For example, if both the expansion force sensor and the internal resistance sensor evaluate that the health status of the power battery is abnormal, the processor will process according to the highest level state, that is, level-one health level state corresponding to the expansion force, and prompt the operator that an extremely emergency operation is required. For another example, if both the internal resistance sensor and the temperature sensor evaluate that the health status of the power battery is abnormal, the processor will process according to the highest level state, that is, level-two health level state corresponding to the temperature, and prompt the operator that a general emergency operation is required. It should be understood that the comprehensive evaluating method of the processor is not limited to the technical solutions introduced above.

It should be understood that in the present disclosure, when the data collected by the expansion force sensor, the temperature sensor and the internal resistance sensor are all normal, it is determined that the health status of the power battery is normal.

To sum up, the present disclosure provides a power battery and a health evaluating method of a power battery. The power battery includes a cell, an expansion force sensor, a temperature sensor and an internal resistance sensor. The expansion force sensor, the temperature sensor and the internal resistance sensor are all electrically connected to the cell. The expansion force sensor is configured to collect the expansion force of the cell, and evaluate the health status of the power battery based on the expansion force. The temperature sensor is configured to collect the temperature of the cell, and evaluate the health status of the power battery based on the temperature. The internal resistance sensor is configured to collect the internal resistance at the feature position of the cell, and evaluate the health status of the power battery based on the internal resistance. Therefore, the internal resistance at the feature position, the expansion force, and the temperature of the cell can be collected through multiple sensors to evaluate the health status of the battery, thereby monitoring the safety status of the cell in real time and reducing the safety risks of the cell.

During use of lithium batteries, short circuits and other unsafe conditions may occur, causing the temperature of the cell pack in the battery cell to rise, which will not only affect the cycle life of the battery, but may even endanger the safety of the battery. The applicant found through research that in related technology of the lithium battery, the temperature of the cell pack inside the cell cannot be monitored, which affects the stability of the battery.

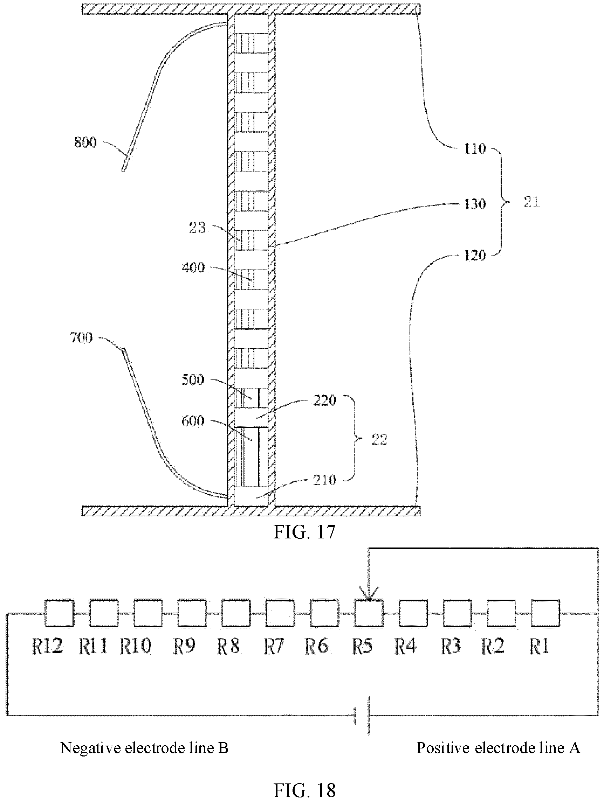

To this end, as shown in FIG. 17 to FIG. 21, some embodiments provide a temperature sensor, and the temperature sensor is applied to a battery pack. The battery pack includes a smart chip and a cell, and the temperature sensor is disposed in the cell and connected to the smart chip. The temperature sensor includes: a sensor bracket 21, a plurality of resistors 22 disposed in the sensor bracket 21, a conductive line 23, and a converting and connecting line 400. The plurality of resistors 22 are connected in series through the conductive line 23. The plurality of resistors 22 include a first resistor 210 and a plurality of second resistors 220. A first channel is disposed between any two adjacent second resistors 220 of the plurality of second resistors 220, and first channels between two adjacent second resistors 220 are connected to each other. One end of the converting and connecting line 400 is connected to the first resistor 210, and the other end of the converting and connecting line 400 passes through the first channels. A conductive liquid 500 and a thermal expansive fluid 600 are further provided in the sensor bracket. The density of the conductive liquid 500 is lower than the density of the thermal expansive fluid 600, and the conductive liquid 500 and the thermal expansive fluid 600 are incompatible with each other. The thermal expansive fluid 600 can push the conductive liquid 500 to move in the first channel after being heated and expanded.

Specifically, as shown in FIG. 17, the conductive liquid 500 and the thermal expansive fluid 600 are disposed at one end of the sensor bracket 21 close to the first resistor 210. Since the density of the conductive liquid 500 is lower than the density of the thermal expansive fluid 600 and the conductive liquid 500 and the thermal expansive fluid are 600 are mutually incompatible, then the thermal expansive fluid 600 is disposed at one end of the sensor bracket 21 close to the first resistor 210, and the conductive liquid 500 is disposed above the thermal expansive fluid 600. In combination with FIG. 18, when short circuit or other unsafe situation occurs during the use of the battery pack, the temperature of the cell pack inside the cell increases. In this case, the thermal expansive fluid 600 in the sensor bracket 21 expands after being heated and pushes the conductive liquid 500 to move in the first channel (i.e. pushing upward), then a short circuit occurs in the resistors 22 in contact with the thermal expansive fluid 600 and the conductive liquid 500. As the temperature of the cell pack 30 inside the cell increasingly rises, the thermal expansive fluid 600 expands more seriously as being heated, and more resistors 22 are short-circuited. The smart chip can determine the temperature of the cell pack inside the cell based on the collected current changes in the circuit composed of the plurality of resistors 22, thereby realizing temperature monitoring of the cell pack inside the cell and improving the safety and reliability of the battery pack.

For example, in combination with FIG. 17 and FIG. 18, when the temperature of the cell pack inside the cell is normal, only the resistor R1 and the resistor R2 are short-circuited. When the temperature of the cell pack inside the cell increases, causing that the thermal expansive fluid 600 pushes the conductive liquid 500 to the position of resistor R5, then resistor R1, resistor R2, resistor R3, resistor R4 and resistor R5 are all short-circuited, and the current of the circuit composed of resistor R1 to resistor R12 increases. The smart chip can determine the number of resistors that are short-circuited in the circuit based on the collected current of the circuit composed of the plurality of resistors 22, and determine the temperature of the cell pack based on the number of resistors that are short-circuited.

In some embodiments, the thermal expansive fluid 600 can be a fluid that can expand when heated. For example, the thermal expansive fluid 600 can be mineral oil. The conductive liquid 500 can be a material with conductive properties, and the density of the conductive liquid 500 is lower than the density of the thermal expansive fluid 600, and the conductive liquid 500 and the thermal expansive fluid 600 are mutually incompatible. For example, when the thermal expansive fluid 600 is mineral oil, the conductive liquid 500 can be liquid lithium.

In some embodiments, the sensor bracket 21 can be made of a plastic bracket. For example, the sensor bracket 21 can be a bracket made of polypropylene (PP) material. Polypropylene is a thermoplastic synthetic resin with excellent performance and is a thermoplastic and lightweight general-purpose plastic that is colorless and translucent. Polypropylene material has chemical resistance, heat resistance, electrical insulation, high-strength mechanical properties and high wear-resistance processing properties. The bracket made of PP material can not only realize the insulation between the plurality of resistors 22 and other components in the cell, and it can also achieve anti-corrosion support for the plurality of resistors 22.

In some embodiments, as shown in FIG. 17, the sensor bracket 21 includes a first bracket 110, a second bracket 120 and a third bracket 130. The first bracket 110 and the second bracket 120 are disposed oppositely. One end of the third bracket 130 is connected to the first bracket 110, and the other end of the third bracket 130 is connected to the second bracket 120. The first bracket 110 may be an upper bracket, and the second bracket 120 may be a lower bracket, or the first bracket 110 may be a lower bracket, and the second bracket 120 may be an upper bracket. For example, as shown in FIG. 17, the first bracket 110 is an upper bracket, and the second bracket 120 is a lower bracket. One end of the third bracket 130 is connected to the center of the first bracket 110, and the other end of the third bracket 130 is connected to the center of the second bracket 120. The first bracket 110, the second bracket 120 and the third bracket 130 form a bracket in a form of Chinese character " 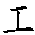 " to facilitate the temperature sensor to be fixed inside the cell.

In some embodiments, the plurality of resistors 22 are disposed in the third bracket 130, and the plurality of resistors 22 are spaced apart along the length direction of the third bracket 130. For example, continuing referring to FIG. 17, the first bracket 110 and the second bracket 120 are disposed in parallel, the third bracket 130 is respectively perpendicular to the first bracket 110 and the second bracket 120. The plurality of resistors 22 are disposed along the direction perpendicular to the first bracket 110 and the second bracket 120. The first resistor 210 is disposed at the lowest end of the sensor bracket 21, and the plurality of second resistors 220 are spaced apart above the first resistor 210.

It should be noted that the plurality of resistors 22 may be disposed with equal spacing or non-equal spacing along the length direction of the third bracket 130. In a specific implementation, continuing referring to FIG. 17, the plurality of second resistors 220 are disposed with equal spacing along the length direction of the third bracket 130, and the distance between the first resistor 210 and the second resistor 220 is greater than the distance between adjacent two ones of the plurality of second resistors 220.

In some embodiments, continuing referring to FIG. 17 to FIG. 19, the temperature sensor further includes a positive electrode line 700 and a negative electrode line 800. One end of the positive electrode line 700 is connected to the first resistor 210, and the other end of the positive electrode line 700 is connected to the smart chip. One end of the negative electrode line 800 is connected to a second resistor 220 of the plurality of second resistors 220 away from the first resistor 210, and the other end of the negative electrode line 800 is connected to the smart chip. In this way, the plurality of resistors 22 and the smart chip can form a circuit as shown in FIG. 18 through the conductive line 23 and the converting and connecting line 400, so that the smart chip can obtain the current value of the circuit and achieve temperature monitoring of the cell pack inside the cell based on the current value.

It should be noted that when the first resistor 210 is disposed at one end of the third bracket 130 close to the second bracket 120, the second resistor 220 of the plurality of second resistors 220 away from the first resistor 210 refers to the second resistor 220 of the plurality of second resistors 220 close to the first bracket 110. As shown in FIG. 17, the second resistor 220 of the plurality of second resistors 220 away from the first resistor 210 refers to the uppermost second resistor 220.

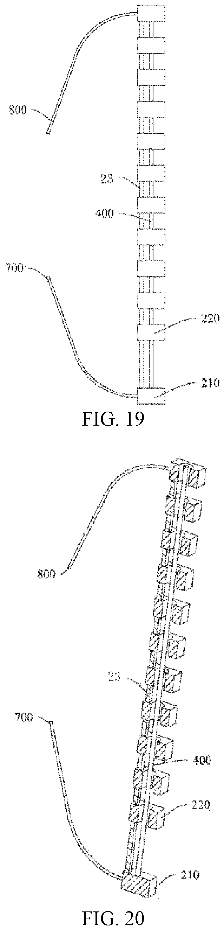

In some embodiments, referring to FIG. 19 to FIG. 21, when the other end of the converting and connecting line 400 passes through the first channel, the converting and connecting line 400 may extend to the second resistor 220 of the plurality of second resistors 220 away from the first resistor 210, that is, the second resistor 220 close to the first bracket 110, so that multiple different temperatures can be monitored. It is apparent that the converting and connecting line 400 in the present disclosure can also extend to the positions of other second resistors 220 of the plurality of second resistors 220. For example, in combination with FIG. 18, the converting and connecting line 400 extends to the positions corresponding to the resistor R2, resistor R3, resistor R4... resistor R11 and the like, which are not limited in the present disclosure.

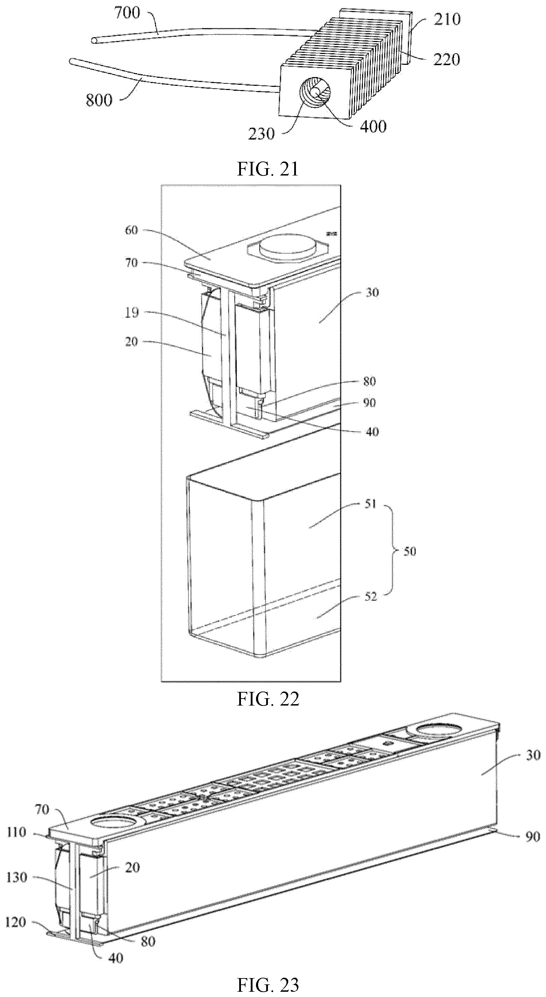

In some embodiments, in combination with FIG. 20 and FIG. 21, the second resistor 220 is provided with a second channel 230 penetrating the upper surface and the lower surface of the second resistor 220. The orthographic projection of the second channel 230 on the first resistor 210 is overlapped with the orthographic projection of the first channel on the first resistor 210. With such an arrangement, the first channels between two adjacent second resistors 220 can be communicated with each other, so that when the thermal expansive fluid 600 thermally expands, the second resistors 220 in contact with the thermal expansive fluid 600 and the conductive liquid 500 are short-circuited.

Some embodiments further provide a battery pack. Referring to FIG. 22 and FIG. 23, the battery pack includes a smart chip, a cell, and the temperature sensor 19 in any one of the embodiments described above, and the temperature sensor 19 is disposed in the cell and is connected to the smart chip. In the battery pack, a first resistor 210 and a plurality of second resistors 220 are disposed in the sensor bracket 21, a first channel is disposed between any two adjacent second resistors 220 of the plurality of second resistors 220, and the first channels between two adjacent second resistors 220 are connected to each other. One end of the conversion connecting line 400 is connected to the first resistor 210, the other end of the converting and connecting line 400 passes through the first channel, and the thermal expansive fluid 600 is heated and expanded to push the conductive liquid 500 to move in the first channel, which can convert the temperature signal in the cell into an electrical signal to realize temperature monitoring of the cell pack inside the cell and improve the safety and reliability of the battery pack. In addition, various components of the temperature sensor are disposed in the sensor bracket, so that various components of the temperature sensor can be protected against corrosion.

It should be noted that the battery pack can include one or more cells. When the battery pack includes a plurality of cells, each of the cells is provided with the temperature sensor 19 in any one of the embodiments described above, thereby realizing the temperature monitoring of the cell pack inside each cell in the battery pack.

In one example, the temperature measuring range of the temperature sensor 19 is -40°C to 80°C. For example, the temperatures that the temperature sensor 19 can measure include but are not limited to -40°C, -20°C, 0, 20°C, 40°C, 60°C. °C, 80 °C, the temperature sensor 19 can meet the temperature measurement requirements of the battery pack within this temperature measuring range.

In some embodiments, continuing referring to FIG. 22 and FIG. 23, the cell includes tabs 20, a cell pack 30 and pins 40. The cell pack 30 and pins 40 are connected through the tabs 20, and the sensor bracket 21 and the pins 40 are disposed in a fitting manner. With such an arrangement, when a short circuit or other unsafe situation occurs during use of the battery pack, the temperature sensor 19 can monitor the temperature of the pin 40 and the cell pack 30 to realize the temperature monitoring of the cell pack 30 inside the cell.

In some embodiments, continuing referring to FIG. 22, the cell further includes a housing 50, the housing 50 includes a bottom plate 52 and side plates 51, and the bottom plate 52 and the side plates 51 enclose to form an accommodating space. The tabs 20, the cell pack 30, the pins 40 and the temperature sensor 19 are disposed in the accommodating space. With such an arrangement, the tabs 20, the cell pack 30, the pins 40 and the temperature sensor 19 can be protected in the housing 50 to avoid damage to the cell. The housing 50 can be made of metal material. For example, the housing 50 can be made of aluminum material.

In some embodiments, continuing referring to FIG. 22 and FIG. 23, the cell further includes a cover plate 60 and a lower plastic 70. The cover plate 60 is connected to the side plates 51 of the housing 50. The lower plastic 70 is disposed between the cover plate 60 and the cell pack 30. The sensor bracket 21 includes a first bracket 110 and a second bracket 120. The first bracket 110 and the second bracket 120 are disposed oppositely. The first bracket 110 is disposed on the surface of the lower plastic 70 away from the cover plate 60, and the second bracket 120 is disposed on the bottom plate 52, so that the temperature sensor 19 can be pressed and fixed up and down through the lower plastic 70 and the bottom plate 52.

In some embodiments, the height of the sensor bracket 21 is equal to the distance between the lower plastic 70 and the bottom plate 52, and the width of the sensor bracket 21 is equal to the width of the housing 50. The height of the sensor bracket 21 refers to the vertical distance from the top end of the first bracket 110 to the bottom end of the second bracket 120, and the width of the sensor bracket 21 is equal to the length of the first bracket 110 and/or the second bracket 120. For example, the length of the first bracket 110 is equal to the length of the second bracket 120, the width of the sensor bracket 21 is equal to the length of the first bracket 110, and the width of the sensor bracket 21 is also equal to the length of the second bracket 120. With such an arrangement, the pressing and fixation up and down of the temperature sensor 19 can be achieved through the lower plastic 70 and the bottom plate 52, and the fixation of the temperature sensor 19 in the front and back direction can be realized through the side plates 51.

In some embodiments, continuing referring to FIG. 22 and FIG. 23, the cell further includes pin patches 80. The pin patch 80 is disposed on a surface of the pin 40 close to the cell pack 30. By disposing the pin patch 80, direct contact between the pin 40 and the cell pack 30 can be avoided, thereby improving the safety of the battery pack.

In some embodiments, continuing referring to FIG. 23, the cell further includes a protective film 90. The protective film 90 is disposed between the cell pack 30 and the bottom plate 52. The protective film 90 can be a polycarbonate (PC) film or a polyethyleneterephthalate (PET) film. The protective film 90 can prevent the cell pack 30 from directly contacting the bottom plate 52, which can not only insulate and protect the cell pack 30, but also prevent the inner protective film on the cell pack 30 from wearing.

## Claims

1. A monitoring system of a battery, **characterized in that** the monitoring system comprises:
a data transmitting channel, a temperature collecting device, a stress collecting device and a data processing device;
wherein the data transmitting channel is connected to the temperature collecting device, the data transmitting channel is connected to the stress collecting device, and the data transmitting channel is connected to the data processing device; and
wherein the temperature collecting device is configured to collect a temperature information of the battery, the stress collecting device is configured to collect a stress information of the battery, the data transmitting channel is configured to transmit the temperature information and the stress information to the data processing device, and the data processing device is configured to receive the temperature information and the stress information, and determine a working health status of the battery based on the temperature information and the stress information.

2. The monitoring system of a battery according to claim 1, **characterized in that** the battery comprises a first cell and a second cell, and the stress collecting device comprises a plurality of expansion force collecting devices;
wherein the data transmitting channel comprises a first section and a second section that are integrally formed, the first section is fixed on a fitting surface between the first cell and the second cell, and the second section is led out from the fitting surface between the first cell and the second cell and then is disposed around a periphery of the first cell and a periphery of the second cell; and
the temperature collecting device is connected to the first section and is fixed on the fitting surface between the first cell and the second cell through at least one fixing element of a plurality of fixing elements, and each of the plurality of expansion force collecting devices is connected to the second section and is respectively fixed on the periphery of the first cell and the periphery of the second cell through at least one fixing element of the plurality of fixing elements.

3. The monitoring system of a battery according to claim 2, **characterized in that** the first cell comprises a first plane and a second plane that are integrally formed, a plane where the first plane is located is not parallel to a plane where the second plane is located, the second cell comprises a third plane and a fourth plane that are integrally formed, and a plane where the third plane is located is not parallel to a plane where the fourth plane is located;
at least one of the plurality of expansion force collecting devices fixed on the periphery of the first cell is disposed between the first cell and the data transmitting channel in a clamped manner, and at least one of the plurality of expansion force collecting devices fixed on the periphery of the second cell is disposed between the second cell and the data transmitting channel in a clamped manner; and
at least two ones of the plurality of expansion force collecting devices are disposed on each of the first plane and the third plane respectively, and at least one of the plurality of expansion force collecting devices is disposed on each of the second plane and the fourth plane respectively.

4. The monitoring system of a battery according to any one of claims 1 to 3, **characterized in that** the data processing device comprises a data processing chip or a data processing terminal; and
when the data processing device comprises the data processing chip, the monitoring system further comprises the data processing chip.

5. The monitoring system of a battery according to claim 4, **characterized in that** the stress information comprises an expansion force information, the data processing device receiving the temperature information and the stress information, and determining a working health status of the battery according to the temperature information and the stress information comprises:
the data processing device receives the temperature information and the expansion force information of the battery under each of different working conditions;
the data processing device analyzes the temperature information and the expansion force information under each of the different working conditions to obtain a temperature alarming threshold and an expansion force alarming threshold of the battery under each of the different working conditions;
the data processing device receives a current temperature information and a current expansion force information of the battery under a current working condition, and processes the current temperature information and the current expansion force information according to remaining battery power of the battery to obtain a temperature information processing result corresponding to the current temperature information and an expansion force information processing result corresponding to the current expansion force information;
the data processing device compares the temperature information processing result with the temperature alarming threshold to obtain a first comparison result, and the data processing device compares the expansion force information processing result with the expansion force alarming threshold to obtain a second comparison result; and
determines the working health status of the battery according to the first comparison result and the second comparison result.

6. The monitoring system of a battery according to claim 5, **characterized in that** the data processing device is further configured to analyze the current temperature information and the current expansion force information of each of a plurality of batteries in a battery module to obtain a first analysis result corresponding to the current temperature information of each of the plurality of batteries in the battery module and a second analysis result corresponding to the current expansion force information of each of the plurality of batteries in the battery module, and the battery module comprises the plurality of batteries;
the data processing device integrates the temperature alarming threshold and the expansion force alarming thresholds of each of the plurality of batteries in the battery module under the current working condition to obtain a comprehensive temperature alarming threshold and a comprehensive expansion force alarming threshold of the battery module under the current working condition;
the data processing device compares the first analysis result with the comprehensive temperature alarming threshold to obtain a third comparison result, and the data processing device compares the second analysis result with the comprehensive expansion force alarming threshold to obtain a fourth comparison result; and
the data processing device predicts a battery module life of the battery module based on the third comparison result and the fourth comparison result.

7. The monitoring system of a battery according to claims 2 or 3, **characterized in that** the first section of the data transmitting channel is fixed on the fitting surface between the first cell and the second cell in a circular shape, and a number of turns of the circular shape is at least one; and
the plurality of fixing elements do not cover the temperature collecting device, and each of the plurality of fixing elements comprises an adhesive tape.

8. The monitoring system of a battery according to claim 4, **characterized in that** the battery further comprises a cover plate; the cover plate covers the first cell and the second cell; and
a wiring hole is disposed on the cover plate, when the data processing device comprises the data processing chip, the data processing device is fixed on the cover plate, after the second section of the data transmitting channel is disposed around the periphery of the first cell and the periphery of the second cell, the second section is led out from the wiring hole and is connected to the data processing chip, and a material of the cover plate comprises an aluminum cover plate.

9. The monitoring system of a battery according to claim 8, **characterized in that** a filling element is respectively disposed between the cover plate and the first cell as well as the cover plate and the second cell, and the filling element is configured to seal and fix the first cell and the second cell; and
wherein the filling element comprises a sealant and/or a sealing ring.

10. A battery, **characterized in that** the battery comprises a first cell, a second cell, and the monitoring system of a battery according to any one of claims 1 to 9.

11. A power battery, **characterized in that** the power battery comprises:
a cell pack comprising a cell and tabs led out from the cell, wherein the tabs comprise a positive electrode tab and a negative electrode tab;
a top cover, wherein soft connecting members are disposed on an inner side surface of the top cover, poles are disposed on an outer side surface of the top cover, and each of the poles is connected to each of the tabs through each of the soft connecting members; and
a resistance sensor comprising a sensor chip and a plurality of collecting wire harnesses, wherein the sensor chip is disposed on the outer side surface of the top cover, a first end of each of the plurality of collecting wire harnesses is connected to the sensor chip, a second end of each of the plurality of collecting wire harnesses is respectively disposed on each of the tabs, each of the soft connecting members and each of the poles, and is respectively configured to collect an internal resistance between the positive electrode tab and the negative electrode tab, an internal resistance between each of the tabs and each of the soft connecting members, and an internal resistance between each of the soft connecting members and each of the poles, and the sensor chip detects a health status of the power battery based on the internal resistance between the positive electrode tab and the negative electrode tab, the internal resistance between each of the tabs and each of the soft connecting members, and the internal resistance between each of the soft connecting members and each of the poles.

12. The power battery according to claim 11, **characterized in that** each of the tabs comprises a first fixing area, and each of the tabs is fixed to each of the soft connecting members by the first fixing area; and
the plurality of collecting wire harnesses comprise collecting wire harnesses of tabs, a second end of each of the collecting wire harnesses of tabs is disposed on an area of each of the tabs except for the first fixing area.

13. The power battery according to claim 12, **characterized in that** each of the soft connecting members comprises a second fixing area, and each of the soft connecting members is fixed to each of the tabs by the second fixing area; and
the plurality of collecting wire harnesses further comprise collecting wire harnesses of collecting members, a second end of each of the collecting wire harnesses of collecting members is disposed in an area of each of the soft connecting members except for the second fixing area, and the collecting wire harnesses of collecting members and the collecting wire harnesses of tabs collect the internal resistance between each of the tabs and each of the soft connecting members.

14. The power battery according to claims 12 or 13, **characterized in that** the collecting wire harnesses of tabs comprise a collecting wire harness of a positive electrode tab and a collecting wire harness of a negative electrode tab, a second end of the collecting wire harness of the positive electrode tab and a second of the collecting wire harness of the negative electrode tab are respectively disposed on the positive electrode tab and the negative electrode tab, and are configured to collect the internal resistance between the positive electrode tab and the negative electrode tab.

15. The power battery according to claim 14, **characterized in that** the second end of the collecting wire harness of the positive electrode tab and the second of the collecting wire harness of the negative electrode tab are respectively disposed at a middle position of each of the positive electrode tab and the negative electrode tab.

16. The power battery according to claim 13, **characterized in that** the soft connecting members are fixed on the inner side surface of the top cover, and the plurality of collecting wire harnesses further comprise collecting wire harnesses of poles; and
the second end of each of the collecting wire harnesses of connecting members is disposed on a side surface of each of the soft connecting members away from the inner side surface, a second end of each of the collecting wire harnesses of poles is disposed on each of the poles, and the collecting wire harnesses of poles and the collecting wire harnesses of connecting members collect the internal resistance between each of the soft connecting members and each of the poles.

17. The power battery according to claim 11, **characterized in that** the resistance sensor is an optical fiber sensor, and the plurality of collecting wire harnesses are optical fiber wire harnesses of the optical fiber sensor, the top cover is provided with a through hole penetrating the top cover, and multiple ones of the optical fiber wire harnesses corresponding to the tabs and the soft connecting members are led out to an outside of the top cover through the through hole.

18. A health detecting method of a power battery, **characterized in that** the power battery comprises the power battery according to any one of claims 11 to 17, and the health detecting method comprises:
collecting the internal resistance between the positive electrode tab and the negative electrode tab, the internal resistance between each of the tabs and each of the soft connecting members, and the internal resistance between each of the soft connecting members and each of the poles of the power battery through the resistance sensor; and
detecting the health status of the power battery according to the internal resistance between the positive electrode tab and the negative electrode tab, the internal resistance between each of the tabs and each of the soft connecting members, and the internal resistance between each of the soft connecting members and each of the poles of the power battery through the sensor chip of the resistance sensor.

19. The health detecting method according to claim 18, **characterized in that** detecting the health status of the power battery according to the internal resistance between the positive electrode tab and the negative electrode tab, the internal resistance between each of the tabs and each of the soft connecting members, and the internal resistance between each of the soft connecting members and each of the poles of the power battery comprises:
determining whether a short circuit fault occurs between the positive electrode tab and the negative electrode tab of the power battery according to the internal resistance between the positive electrode tab and the negative electrode tab;
determining whether a fault occurs in a fixation between each of the tabs and each of the soft connecting members according to the internal resistance between each of the tabs and each of the soft connecting members; and
determining whether a fault occurs in a fixation between each of the soft connecting members and each of the poles according to the internal resistance between each of the soft connecting members and each of the poles.

20. The health detecting method according to claim 19, **characterized in that** the determining whether a short circuit fault occurs between the positive electrode tab and the negative electrode tab of the power battery according to the internal resistance between the positive electrode tab and the negative electrode tab further comprises:
if the internal resistance between the positive electrode tab and the negative electrode tab is less than a first internal resistance threshold, determining that a short circuit fault occurs between the positive electrode tab and the negative electrode tab of the power battery;
determining whether a fault occurs in a fixation between each of the tabs and each of the soft connecting members according to the internal resistance between each of the tabs and each of the soft connecting members further comprises:
if the internal resistance between each of the tabs and each of the soft connecting members is greater than a second internal resistance threshold, determining that a fault occurs in the fixation between each of the tabs and each of the soft connecting members; and
determining whether a fault occurs in a fixation between each of the soft connecting members and each of the poles according to the internal resistance between each of the soft connecting members and each of the poles further comprises:
if the internal resistance between each of the soft connecting members and each of the poles is greater than the second internal resistance threshold, determining that a fault occurs in the fixation between each of the soft connecting members and each of the poles.

21. A power battery, **characterized in that** the power battery comprises one or more cells, an expansion force sensor, a temperature sensor, and an internal resistance sensor, and each of the expansion force sensor, the temperature sensor, and the internal resistance sensor is electrically connected to each of the one or more cells, wherein
the expansion force sensor is configured to collect one or more expansion forces of each of the one or more cells, and evaluate a health status of the power battery based on the one or more expansion forces;
the temperature sensor is configured to collect one or more temperatures of each of the one or more cells, and evaluate the health status of the power battery based on the one or more temperatures; and
the internal resistance sensor is configured to collect one or more internal resistances at one or more feature positions of each of the one or more cells, and evaluate the health status of the power battery based on the one or more internal resistances.

22. The power battery according to claim 21, **characterized in that** the power battery comprises a housing, and the one or more cells are disposed in the housing;
wherein the expansion force sensor comprises a plurality of first collecting ends, a first transmitting line, a second transmitting line and a first processor, wherein:
the plurality of first collecting ends are disposed between each of the one or more cells and the housing, and are located at multiple positions of each of the one or more cells, and the plurality of first collecting ends are configured to collect multiple pressures at the multiple positions between each of the one or more cells and the housing after expansion of each of the one or more cells to serve as said multiple expansion forces;
the first transmitting line is connected to the plurality of first collecting ends and is configured to obtain said multiple expansion forces collected by the plurality of first collecting ends; and
one end of the second transmitting line is connected to the first transmitting line, another end of the second transmitting line is connected to the first processor, and the second transmitting line is configured to transmit said multiple expansion forces obtained by the first transmitting line to the first processor.

23. The power battery according to claim 21, **characterized in that** the expansion force sensor comprises a second collecting end, a third transmitting line and a first processor; wherein:
the second collecting end is a collecting coil wound around an outer periphery of each of the one or more cells and has elasticity, the second collecting end is configured to collect an elastic force of the collecting coil stretched caused by expansion of each of the one or more cells to serve as the one or more expansion forces; and
one end of the third transmitting line is connected to the collecting coil, and another end of the third transmitting line is connected to the first processor, and the third transmitting line is configured to transmit the one or more expansion forces collected by the collecting coil to the first processor.

24. The power battery according to any one of claims 21 to 23, **characterized in that** the temperature sensor comprises a third collecting end, a fourth transmitting line and a second processor, wherein:
the third collecting end is a spiral line and is disposed on a side surface of each of the one or more cells, and the third collecting end is configured to collect multiple temperatures at multiple positions on the side surface; and
one end of the fourth transmitting line is connected to the third collecting end, another end of the fourth transmitting line is connected to the second processor, and the fourth transmitting line is configured to transmit the multiple temperatures at the multiple positions to the second processor.

25. The power battery according to claim 24, **characterized in that** one cellof the one or more cells is provided, and the third collecting end is disposed on a side surface with a largest area of the cell; or
at least two cells of the cells are provided, and the third collecting end is disposed between two adjacent cells of the at least two cells and is connected to a side surface of each of the two adjacent cells.

26. The power battery according to any one of claims 21 to 23, **characterized in that** the power battery comprises tabs electrically connected to each of the one or more cells, and the tabs comprise a positive electrode tab and a negative electrode tab; and
the internal resistance sensor comprises a third processor and a fourth collecting end, the fourth collecting end comprises first collecting wire harnesses, one end of each of the first collecting wire harnesses is connected to the positive electrode tab and the negative electrode tab respectively, another end of each of the first collecting wire harnesses is connected to the third processor, and each of the first collecting wire harnesses is configured to transmit an internal resistance collected between the positive electrode tab and the negative electrode tab to the third processor.

27. The power battery according to claim 26, **characterized in that** the power battery comprises a top cover, soft connecting members are disposed on an inner side surface of the top cover, and poles are disposed on an outer side surface of the top cover, each of the poles is connected to each of the tabs through each of the soft connecting members; and the fourth collecting end further comprises:
second collecting wire harnesses, one end of each of the second collecting wire harnesses is connected to each of the soft connecting members, another end of each of the second collecting wire harnesses is connected to the third processor, and each of the second collecting wire harnesses is configured to collect an internal resistance between each of the tabs and each of the soft connecting members together with each of the first collecting wire harnesses and transmit the internal resistance to the third processor; and third collecting wire harnesses, one end of each of the third collecting wire harnesses is connected to each of the poles, and another end of each of the third collecting wire harnesses is connected to the third processor, and each of the third collecting wire harnesses is configured to collect an internal resistance between each of the soft connecting members and each of the poles together with each of the second collecting wire harnesses and transmit the internal resistance to the third processor.

28. A health evaluating method of a power battery, **characterized in that** the power battery comprises the power battery according to any one of claims 21 to 27, and the health evaluating method comprises:
collecting the one or more expansion forces of each of the one or more cells of the power battery through the expansion force sensor, and evaluating the health status of the power battery based on the one or more expansion forces;
collecting the one or more temperatures of each of the one or more cells through the temperature sensor, and evaluating the health status of the power battery based on the one or more temperatures;
collecting the one or more internal resistances at the one or more feature positions of each of the one or more cells through the internal resistance sensor, and evaluating the health status of the power battery based on the one or more internal resistances; and further evaluating the health status of the power battery based on an evaluating result of the expansion force sensor, an evaluating result of the temperature sensor, and an evaluating result of the internal resistance sensor through a processor.

29. The health evaluating method according to claim 28, **characterized in that** the power battery comprises a housing, and
the one or more cells are disposed in the housing;
the collecting the one or more expansion forces of each of the one or more cells of the power battery through the expansion force sensor, and evaluating the health status of the power battery based on the one or more expansion forces comprises:
collecting multiple pressures at multiple positions between each of the one or more cells and the housing after expansion of each of the one or more cells through the expansion force sensor to serve as said multiple expansion forces, and evaluating the health status of the power battery based on said multiple expansion forces.

30. The health evaluating method according to claims 28 or 29, **characterized in that** the collecting the one or more temperatures of each of the one or more cells through the temperature sensor, and evaluating the health status of the power battery based on the one or more temperatures further comprises:
collecting multiple temperatures at multiple positions on a side surface of each of the one or more cells through the temperature sensor, and evaluating the health status of the power battery based on the multiple temperatures.

31. A temperature sensor applied to a battery pack, **characterized in that** the battery pack comprises a smart chip and a cell, the temperature sensor is disposed in the cell and connected to the smart chip, the temperature sensor comprises: a sensor bracket, a plurality of resistors disposed in the sensor bracket, a conductive line, and a converting and connecting line, and the plurality of resistors are connected in series through the conductive line; and
wherein the plurality of resistors comprise a first resistor and a plurality of second resistors, a first channel is disposed between any two adjacent second resistors of the plurality of second resistors, first channels between two adjacent second resistors of the plurality of second resistors are connected to each other, one end of the converting and connecting line is connected to the first resistor, and another end of the converting and connecting line passes through each of the first channels, a conductive liquid and a thermal expansive fluid are further provided in the sensor bracket, a density of the conductive liquid is lower than a density of the thermal expansive fluid and the conductive liquid and the thermal expansive fluid are mutually incompatible, and the thermal expansive fluid pushes the conductive liquid to move in the first channels after being heated and expanded.

32. The temperature sensor according to claim 31, **characterized in that** the sensor bracket comprises a first bracket, a second bracket and a third bracket, the first bracket and the second bracket are disposed oppositely, one end of the third bracket is connected to the first bracket, and another end of the third bracket is connected to the second bracket.

33. The temperature sensor according to claim 32, **characterized in that** the plurality of resistors are disposed in the third bracket, and the plurality of resistors are spaced apart along a length direction of the third bracket.

34. The temperature sensor according to any one of claims 31 to 33, **characterized in that** the temperature sensor further comprises a positive electrode line and a negative electrode line, one end of the positive electrode line is connected to the first resistor, another end of the positive electrode line is connected to the smart chip, one end of the negative electrode line is connected to a second resistor of the plurality of second resistors away from the first resistor, and another end of the negative electrode line is connected to the smart chip.

35. The temperature sensor according to any one of claims 31 to 33, **characterized in that** each of the plurality of second resistors is provided with a second channel penetrating an upper surface and a lower surface of each of the plurality of second resistors, the first channels between two adjacent second resistors the plurality of second resistors are communicated with each other through the second channel, and an orthographic projection of the second channel on the first resistor is overlapped with an orthographic projection of each of the first channels on the first resistor.

36. A battery pack **characterized by** comprising a smart chip, a cell and the temperature sensor according to any one of claims 31 to 35, wherein the cell comprises tabs, a cell pack and one or more pins, the cell pack is connected to each of one or more pins through each of the tabs, the sensor bracket and the one or more pins are disposed in a fitting manner, and the sensor bracket is connected to the smart chip.

37. The battery pack according to claim 36, **characterized in that** a temperature measuring range of the temperature sensor is -40°C to 80°C.

38. The battery pack according to claim 36, **characterized in that** the cell further comprises a housing, the housing comprises a bottom plate and side plates, the bottom plate and the side plates enclose to form an accommodating space, and the tabs, the cell pack, the one or more pins and the temperature sensor are disposed in the accommodating space.

39. The battery pack according to claim 38, **characterized in that** the cell further comprises a cover plate and a lower plastic, the cover plate is connected to the housing, the lower plastic is disposed between the cover plate and the cell pack, the sensor bracket comprises a first bracket and a second bracket, the first bracket and the second bracket are disposed oppositely, the first bracket is disposed on a surface of the lower plastic away from the cover plate, and the second bracket is disposed on the bottom plate.

40. The battery pack according to claim 39, **characterized in that** a height of the sensor bracket is equal to a distance between the lower plastic and the bottom plate, and a width of the sensor bracket is equal to a width of the housing.
